# EUROPEAN PATENT APPLICATION

(11) **EP 4 333 060 A1**
(43) Date of publication of application: **06.03.2024**
(21) Application number: 23194734.2
(22) Date of filing: 31.08.2023
(51) Int. Cl.: H01L 27/02, H10B 41/10, H10B 43/10, H10B 41/50, H10B 43/50

(54) **SEMICONDUCTOR DEVICES AND DATA STORAGE SYSTEMS INCLUDING THE SAME**

(30) Priority: 02.09.2022 KR 20220111098
(71) Applicant: Samsung Electronics Co., Ltd., Suwon-si, Gyeonggi-do 16677 (KR)
(72) Inventor: KWON, Joonyoung, 16677 Suwon-si (KR); JEONG, Dawoon, 16677 Suwon-si (KR); KIM, Jiyoung, 16677 Suwon-si (KR); SUNG, Sukkang, 16677 Suwon-si (KR); YANG, Woosung, 16677 Suwon-si (KR)
(74) Representative: Marks & Clerk LLP

(57) **Abstract**

A semiconductor device includes a first conductive plate structure and a second conductive plate structure, arranged at a same vertical level on a semiconductor chip and horizontally spaced apart from each other on the semiconductor chip, a first structure on the first conductive plate structure and including first separation structures and first memory blocks, and a second structure on the second conductive plate structure and including second separation structures and second memory blocks. The first memory blocks are spaced apart from each other by the first separation structures, and extend in parallel to each other in a first horizontal direction. The second memory blocks are spaced apart from each other by the second separation structures, and extend in parallel to each other in a second horizontal direction. The first and second horizontal directions are parallel to an upper surface of the first conductive plate structure, and are perpendicular to each other.

## Description

### BACKGROUND

Aspects of the present disclosure relate to semiconductor devices and data storage systems including the same.

In electronic systems that require data storage, semiconductor devices capable of storing high-capacity data are in great demand. Accordingly, methods of increasing data storage capacity of semiconductor devices have been researched. For example, as a method of increasing data storage capacity of a semiconductor device, a semiconductor device that includes memory cells arranged three-dimensionally, instead of memory cells arranged two-dimensionally, has been proposed.

### SUMMARY

Some aspects of the present disclosure provide semiconductor devices having increased degrees of integration and reliability.

Some aspects of the present disclosure provide data storage systems including semiconductor devices having increased degrees of integration and reliability.

According to some example embodiments, a semiconductor device may include a first conductive plate structure and a second conductive plate structure, arranged on a same vertical level on a semiconductor chip and horizontally spaced apart from each other on the semiconductor chip, a first structure on the first conductive plate structure and including first separation structures and first memory blocks, and a second structure on the second conductive plate structure and including second separation structures and second memory blocks. The first memory blocks are spaced apart from each other by the first separation structures, and extend in parallel to each other in a first horizontal direction. The second memory blocks are spaced apart from each other by the second separation structures, and extend in parallel to each other in a second horizontal direction. The first and second horizontal directions may be parallel to an upper surface of the first conductive plate structure, and are perpendicular to each other.

According to some example embodiments, a semiconductor device may include first word lines stacked in a vertical direction and spaced apart from each other, the first word lines extending in a first horizontal direction, second word lines stacked in the vertical direction, spaced apart from each other, and at substantially at the same level as the first word lines, the second word lines extending in a second horizontal direction that is perpendicular to the first horizontal direction, a first vertical memory structure, extending through the first word lines, in the vertical direction, a second vertical memory structure, extending through the second word lines, in the vertical direction, a first bit line, electrically connected to the first vertical memory structure, on the first vertical memory structure, and a second bit line, electrically connected to the second vertical memory structure, on the second vertical memory structure.

According to some example embodiments, a data storage system includes a semiconductor device including an input/output pad, and a controller electrically connected to the semiconductor device through the input/output pad, the controller configured to control the semiconductor device. The semiconductor device includes a first conductive plate structure and a second conductive plate structure, arranged at the same vertical level on a semiconductor chip and spaced apart from each other on the semiconductor chip, a first structure on the first conductive plate structure and including first separation structures and first memory blocks, and a second structure on the second conductive plate structure and including second separation structures and second memory blocks. The first memory blocks are spaced apart from each other by the first separation structures, and extend in parallel to each other in a first horizontal direction. The second memory blocks are spaced apart from each other by the second separation structures, and extend in parallel to each other in a second horizontal direction. The first and second horizontal directions are parallel to an upper surface of the first conductive plate structure, and are perpendicular to each other.

At least some of the above and other features of the invention are set out in the claims.

### BRIEF DESCRIPTION OF DRAWINGS

The above and other aspects, features, and advantages of the present inventive concepts will be more clearly understood from the following detailed description, taken in conjunction with the accompanying drawings, in which:
FIG. 1 is a schematic plan view illustrating a semiconductor device according to some example embodiments;
FIGS. 2A, 2B, and 2C are schematic views illustrating examples of a semiconductor device according to some example embodiments;
FIG. 3 is a schematic cross-sectional view illustrating a modification of a semiconductor device according to some example embodiments;
FIG. 4 is a schematic plan view illustrating a modification of a semiconductor device according to some example embodiments.
FIG. 5 is a schematic cross-sectional view illustrating a modification of a semiconductor device according to some example embodiments;
FIG. 6 is a schematic plan view illustrating an example of some elements of a semiconductor device according to some example embodiments;
FIGS. 7A and 7B are schematic views illustrating a modification of a semiconductor device according to some example embodiments;
FIG. 8A is a schematic plan view illustrating a modification of a semiconductor device according to some example embodiments;
FIGS. 8B, 9A, and 9B are schematic views illustrating modifications of the semiconductor device according to some example embodiments;
FIGS. 10A and 10B are schematic plan views illustrating a modification of a semiconductor device according to some example embodiments;
FIG. 11 is a schematic plan view illustrating a modification of a semiconductor device according to some example embodiments;
FIG. 12 is a schematic plan view illustrating a modification of a semiconductor device according to some example embodiments;
FIG. 13 is a schematic plan view illustrating a modification of a semiconductor device according to some example embodiments;
FIG. 14 is a schematic plan view illustrating a modification of a semiconductor device according to some example embodiments;
FIG. 15 is a schematic plan view illustrating a modification of a semiconductor device according to some example embodiments;
FIG. 16 is a schematic plan view illustrating a modification of a semiconductor device according to some example embodiments;
FIG. 17 is a schematic process flowchart illustrating an example of a method of forming a semiconductor device according to some example embodiments;
FIG. 18 is a schematic view illustrating a data storage system including a semiconductor device according to some example embodiments; and
FIG. 19 is a schematic perspective view illustrating a data storage system including a semiconductor device according to some example embodiments.

### DETAILED DESCRIPTION

Hereinafter, terms such as "upper portion," "intermediate portion," and "lower portion" may be replaced with other terms, for example, "first," "second," and "third" to describe elements of the specification. Terms such as "first," "second," and "third" may be used to describe different elements, with the understanding that the elements are not limited by the terms, and a "first element" may be referred to as a "second element."

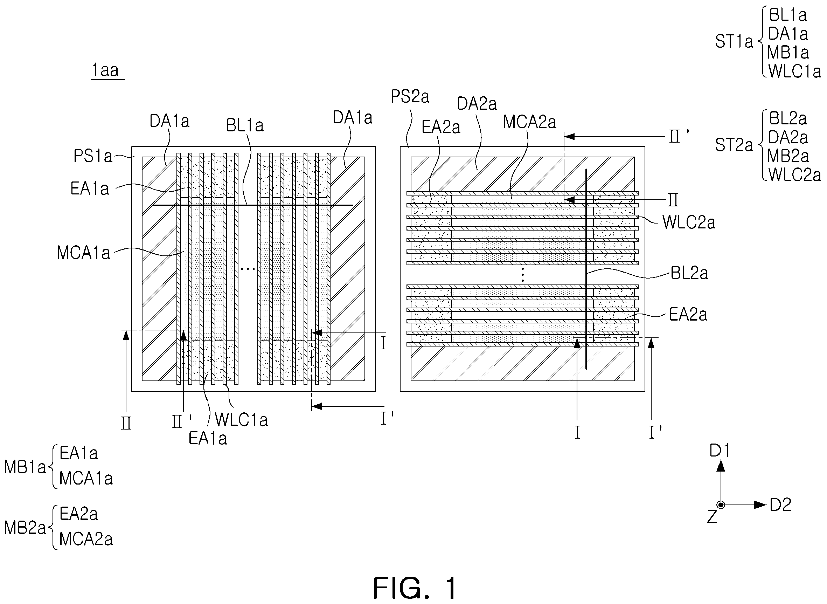

First, with reference to FIG. 1, an example of a semiconductor device according to some example embodiments will be described. FIG. 1 is a schematic plan view illustrating a semiconductor device according to an example embodiment.

Referring to FIG. 1, a semiconductor device 1aa according to some example embodiments may include a first conductive plate structure PS1a and a second conductive plate structure PS2a, which may be provided substantially at the same level in a vertical direction and spaced apart from each other in a horizontal direction. The first conductive plate structure PS1a may include a first common source, and the second conductive plate structure PS2a may include a second common source.

The semiconductor device 1aa may further include a first structure ST1a on the first conductive plate structure PS1a and a second structure ST2a on the second conductive plate structure PS2a.

The first structure ST1a may include first memory blocks MB1a and first separation structures WLC1a.

Each of the first memory blocks MB1a may extend in length in a first horizontal direction D1, which may extend parallel to an upper surface of the first conductive plate structure PS1a. Each of the first separation structures WLC1a may extend in length in the first horizontal direction D1. Each of the first memory blocks MB1a may be between a corresponding pair (e.g., first and second) of the first separation structures WLC1a that are adjacent to each other in a second horizontal direction D2. The second horizontal direction D2 may be parallel to the upper surface of the first conductive plate structure PS1a, and may be perpendicular to the first horizontal direction D1. The first memory blocks MB1a may be spaced apart from each other by the first separation structures WLC1a in the second horizontal direction D2.

Each of the first memory blocks MB1a may include a first memory cell array region MCA1a and a first extension region EA1a that are adjacent to each other in the first horizontal direction D1. In some embodiments, a pair of first extension regions EA1a spaced apart from each other in the first horizontal direction D1 may be provided, and the first memory cell array region MCA1a may be disposed between the pair of first extension regions EA1a.

The first structure ST1a may further include first bit lines BL1a that are parallel to each other. One of the first bit lines BL1a is shown in FIG. 1. Each of the first bit lines BL1a may extend in length in the second horizontal direction D2. The first bit lines BL1a may cross the first memory cell array regions MCA1a of the first memory blocks MB1a on a vertical level that is higher than that of the first memory blocks MB1a.

The first structure ST1a may further include first dummy regions DA1a. The first memory blocks MB1a and the first separation structures WLC1a may be between the first dummy regions DA1a in the second horizontal direction D2.

The second structure ST2a may include second memory blocks MB2a and second separation structures WLC2a. Each of the second memory blocks MB2a may extend in length in the second horizontal direction D2. Each of the second separation structures WLC2a may extend in length in the second horizontal direction D2. Each of the second memory blocks MB2a may be between a corresponding pair (e.g., first and second) of the second separation structures WLC2a that are adjacent to each other in the first horizontal direction D1. The second memory blocks MB2a may be spaced apart from each other by the second separation structures WLC2a in the first horizontal direction D1.

Each of the second memory blocks MB2a may include a second memory cell array region MCA2a and a second extension region EA2a that are adjacent to each other in the second horizontal direction D2. In some embodiments, a pair of second extension regions EA2a spaced apart from each other in the second horizontal direction D2 may be provided, and the second memory cell array region MCA2a may be between the pair of second extension regions EA2a.

The second structure ST2a may further include second bit lines BL2a parallel to each other. One of the second bit lines BL2a is shown in FIG. 1. The second bit lines BL2a may be on a vertical level that is the same as that of the first bit lines BL1a. Each of the second bit lines BL2a may extend in length in the first horizontal direction D1. The second bit lines BL2a may cross the second memory cell array regions MCA2a of the second memory blocks MB2a on a vertical level that is higher than that of the second memory blocks MB2a.

The second structure ST2a may further include second dummy regions DA2a. The second memory blocks MB2a and the second separation structures WLC2a may be between the second dummy regions DA2a in the first horizontal direction D1.

In example embodiments, a cross-sectional structure of the first structure ST1a in the first horizontal direction D1 and a cross-sectional structure of the second structure ST2a in the second horizontal direction D2 may be substantially the same, and a cross-sectional structure of the first structure ST1a in the second horizontal direction D2 and a cross-sectional structure of the second structure ST2a in the first horizontal direction D1 may be substantially the same. For example, in FIG. 1, a cross-sectional structure of the first structure ST1a taken along line I-I' and a cross-sectional structure of the second structure ST2a taken along line I-I' may be substantially the same, and a cross-sectional structure of the first structure ST1a taken along line II-II' and a cross-sectional structure of the second structure ST2a taken along line II-II' may be substantially the same.

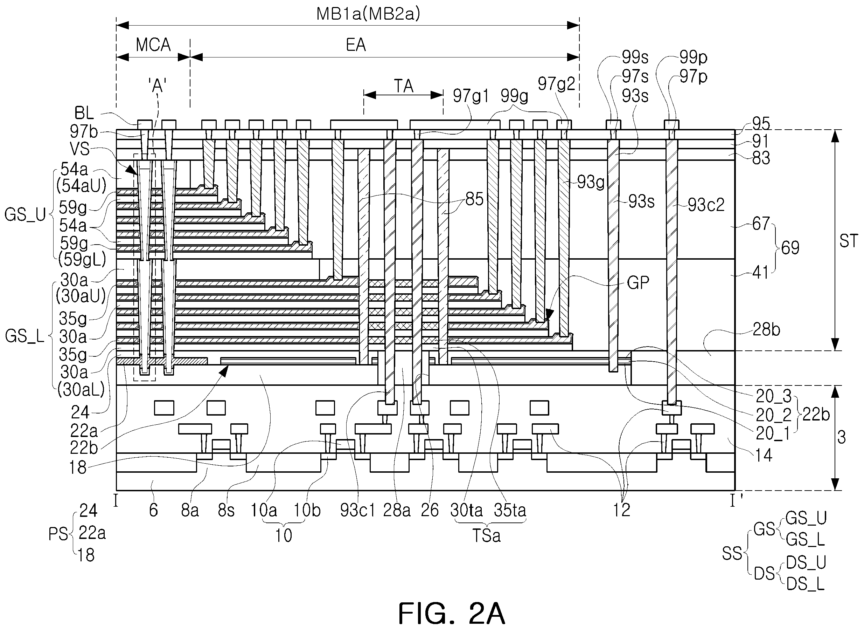

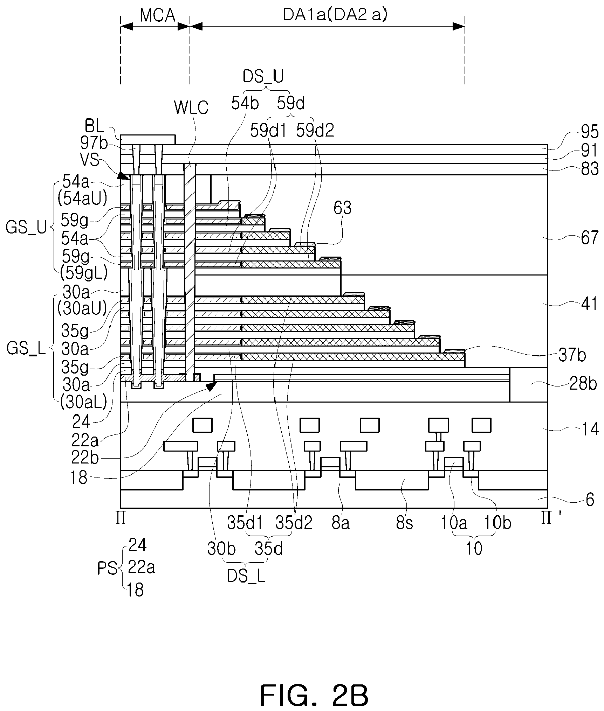

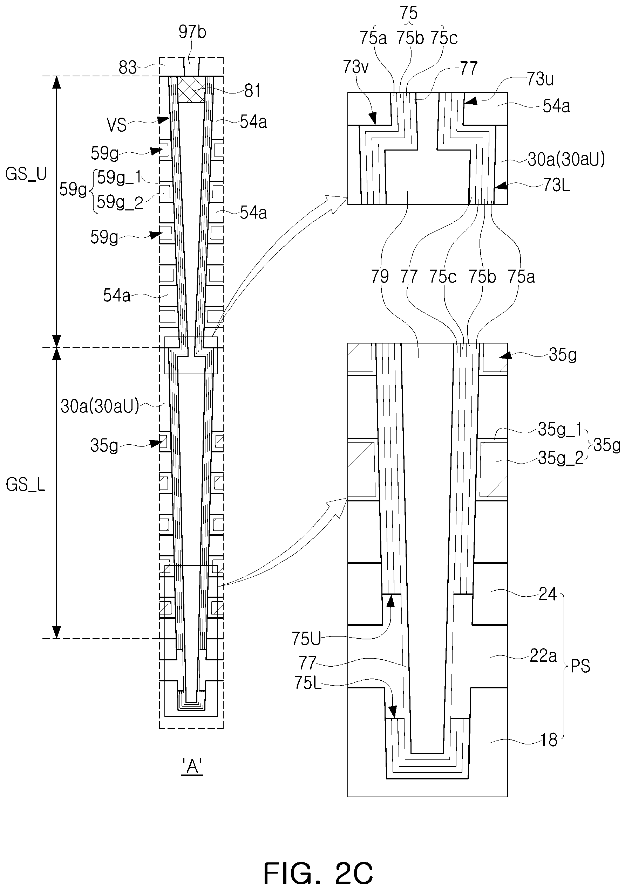

Hereinafter, an example of a cross-sectional structure ST of the semiconductor device 1aa will be described with reference to FIGS. 2A to 2C. In FIGS. 2A to 2C, FIG. 2A is a schematic cross-section view illustrating a cross-sectional structure of the first structure ST1a taken along line I-I' of FIG. 1 and a cross-sectional structure of the second structure ST2a taken along line I-I', FIG. 2B is a schematic cross-section view illustrating a cross-sectional structure of the first structure ST1a taken along line II-II' of FIG. 1 and a cross-sectional structure of the second structure ST2a taken along line II-II', and FIG. 2C is a partially enlarged schematic view illustrating a region indicated by "A" in FIG. 2A.

Referring to FIGS. 2A, 2B, and 2C together with FIG. 1, the semiconductor device 1aa may further include a lower structure 3. The lower structure 3 may include a substrate 6, device isolation regions 8s that define active regions 8a on the substrate 6, peripheral circuits 10 on the active regions 8a, a peripheral circuit wiring 12 electrically connected to the peripheral circuits 10 on the peripheral circuits 10, and an insulating structure 14 that covers the peripheral circuits 10 and the peripheral circuit wiring 12. The peripheral circuits 10 may include a transistor including a peripheral gate 10a and a peripheral source/drain 10b. The substrate 6 may be a semiconductor substrate, for example, a silicon substrate or a compound semiconductor substrate.

A conductive plate structure PS may be on the lower structure 3. The conductive plate structure PS may be the first conductive plate structure PS1a or the second conductive plate structure PS2a described with reference to FIG. 1. The conductive plate structure PS may have an opening 26.

The semiconductor device 1aa may further include a gap-fill insulating layer 28a in the opening 26 and an intermediate insulating layer 28b on an outer surface of the conductive plate structure PS.

The conductive plate structure PS may include a lower layer 18, a first intermediate layer 22a on the lower layer 18, and an upper layer 24 covering the first intermediate layer 22a on the lower layer 18.

The conductive plate structure PS may include at least one doped silicon layer, which may be a common source. For example, at least one of the lower layer 18, the first intermediate layer 22a, and the upper layer 24 may include a polysilicon layer having N-type conductivity. For example, the first intermediate layer 22a may be the first common source of the first conductive plate structure PS1a or the second common source of the second conductive plate structure PS2a described with reference to FIG. 1.

The semiconductor device 1aa may further include a second intermediate layer 22b on the lower layer 18 and spaced apart in a horizontal direction from the first intermediate layer 22a. The upper layer 24 may cover the second intermediate layer 22b. The second intermediate layer 22b may include a first layer 20_1, a second layer 20_2, and a third layer 20_3 sequentially stacked. The first and third layers 20_1 and 20_3 may include silicon oxide, and the second layer 20_2 may include silicon nitride or polysilicon.

A stack structure SS may be on the conductive plate structure PS. The stack structure SS may include a gate stack region GS and a dummy stack region DS. The gate stack region GS may include a lower gate stack region GS_L and an upper gate stack region GS_U on the lower gate stack region GS_L. The dummy stack region DS may include a lower dummy stack region DS_L and an upper dummy stack region DS_U on the lower dummy stack region DS_L. Here, "stack region" may be referred to as a stack structure.

The lower gate stack region GS_L may include lower interlayer insulating layers 30a and lower gate layers 35g, which may be alternately and repeatedly stacked. The upper gate stack region GS_U may include upper interlayer insulating layers 54a and upper gate layers 59g, which may be alternately and repeatedly stacked. The lower dummy stack region DS_L may include lower dummy insulating layers 30b and lower dummy horizontal layers 35d, which may be alternately stacked. The upper dummy stack region DS_U may include upper dummy insulating layers 54b and upper dummy horizontal layers 59d, which may be alternately stacked.

In some embodiments, each of the lower gate layers 35g may include a first gate layer 35g_1 and a second gate layer 35g_2. The first gate layer 35g_1 may cover upper and lower surfaces of the second gate layer 35g_2, and may partially cover side surfaces of the second gate layer 35g_2. Similarly, each of the upper gate layers 59g may include a first gate layer 59g_1 and a second gate layer 59g_2. The first gate layer 59g_1 may cover upper and lower surfaces of the second gate layer 59g_2, and may partially cover side surfaces of the second gate layer 59g_2.

In some embodiments, the first gate layers 35g_1 and 59g_1 may include an insulating material, for example, a high-κ dielectric such as aluminum oxide, and the second gate layers 35g_2 and 59g_2 may include a conductive material, for example, at least one of doped polysilicon, W, Ru, Mo, Ni, NiSi, Co, CoSi, Ti, Ta, TiSi, TaSi, TiN, TaN, and WN. In some embodiments, the first gate layers 35g_1 and 59g_1 may include a first conductive material such as TiN, TaN, or WN, and the second gate layers 35g_2 and 59g_2 may include a second conductive material different from the first conductive material, for example, at least one of W, Ru, Mo, Ni, NiSi, Co, CoSi, Ti, Ta, TiSi, and TaSi. In some embodiments, each of the lower and upper gate layers 35g and 59g may be formed of a single conductive material layer, for example, a conductive material layer including at least one of doped polysilicon, W, Ru, Mo, Ni, NiSi, Co, CoSi, Ti, Ta, TiSi, TaSi, TiN, TaN, and WN.

In some example embodiments, a portion of the lower and upper gate layers 35g and 59g formed of a conductive material layer may be referred to as a gate electrode.

The lower gate layers 35g may be stacked and spaced apart from each other in a vertical direction Z in a memory cell array region MCA, and may extend into an extension region EA. The upper gate layers 59g may be stacked while being spaced apart from each other in the vertical direction Z in the memory cell array region MCA, and may extend into the extension region EA.

In the extension region EA, the lower and upper gate layers 35g and 59g may have gate pads GP having an increased thickness. For example, a thickness of at least one of the gate pads GP in the extension region GA may be greater than a thickness of at least one of the lower and upper gate layers 35g and 59g in the memory cell array region MCA. In the extension region EA, the gate pads GP may be arranged to have a stair shape or stair profile. For example, a first lower gate layer 35g may extend a first distance in a horizontal direction, and a second lower gate layer 35g above the first lower gate layer 35g may extend a second distance in the horizontal direction that is less than the first distance.

Among the lower interlayer insulating layers 30a and the lower gate layers 35g, a lowermost layer may be a lowermost lower interlayer insulating layer 30aL, and an uppermost layer may be an uppermost lower interlayer insulating layer 30aU. Among the upper interlayer insulating layers 54a and the upper gate layers 59g, a lowermost layer may be a lowermost upper gate layer 59gL, and an uppermost layer may be an uppermost upper interlayer insulating layer 54aU.

The lower dummy insulating layers 30b and the lower dummy horizontal layers 35d may be on a level substantially the same as those of the lower interlayer insulating layers 30a and the lower gate layers 35g, and may have a stair-shaped end portion. The upper dummy insulating layers 54b and the upper dummy horizontal layers 59d may be on a level substantially the same as those of the upper interlayer insulating layers 54a and the upper gate layers 59g, and have a stair-shaped end portion. The lower dummy insulating layers 30b and the lower interlayer insulating layers 30a may be formed of the same material, for example, silicon oxide. The upper dummy insulating layers 54b and the upper interlayer insulating layers 54a may be formed of the same material, for example, silicon oxide.

In some embodiments, each of the lower dummy horizontal layers 35d may include a first horizontal portion 35d1 and a second horizontal portion 35d2. The first horizontal portion 35d1 may be formed of a material the same as that of the lower gate layers 35g. The second horizontal portion 35d2 may be formed of a material that is different from that of the first horizontal portion 35d1. For example, the first horizontal portion 35d1 may include a conductive material, and the second horizontal portion 35d2 may include an insulating material, for example, silicon nitride, on a level the same as that of the first horizontal portion 35d1.

In some embodiments, at least one of the upper dummy horizontal layers 59d may include a first horizontal portion 59d1 and a second horizontal portion 59d2. The first horizontal portion 59d1 may be formed of a material the same as that of the upper gate layers 59g. The second horizontal portion 59d2 may be formed of a material different from that of the first horizontal portion 59d1. For example, the first horizontal portion 59d1 may include a conductive material, and the second horizontal portion 59d2 may include an insulating material, for example, silicon nitride, on a level the same as that of the first horizontal portion 59d1.

The semiconductor device 1aa may further include a lower capping insulating layer 41, covering the lower gate stack region GS_L and the lower dummy stack region DS_L, on the lower structure 3, and an upper capping insulating layer 67, covering the upper gate stack region GS_U and the upper dummy stack region DS_U, on the lower capping insulating layer 41. The lower and upper capping insulating layers 41 and 67 may be formed of an insulating material such as silicon oxide. The lower and upper capping insulating layers 41 and 67 may be included in a capping structure 69.

The semiconductor device 1aa may further include lower additional insulating layers 37b and upper additional insulating layers 63. The lower additional insulating layers 37b may be on upper surfaces of end portions arranged to have a stair shape of the second horizontal portions 35d2 of the lower dummy horizontal layers 35d. The upper additional insulating layers 63 may be on upper surfaces of end portions arranged to have a stair shape of the second horizontal portions 59d2 of the upper dummy horizontal layers 59d.

The semiconductor device 1aa may further include a through-insulation region TA in the extension region EA. The through-insulation region TA may include a through-insulation structure TSa including interlayer insulating layers 30ta and horizontal insulating layers 35ta, which may be alternately stacked. The through-insulation structure TSa may vertically overlap the gap-fill insulating layer 28a. The through-insulation structure TSa is not limited to a position marked in FIG. 2A, and may be disposed in various forms.

In some example embodiments, the lower gate layers 35g of the lower gate stack region GS_L may not be completely isolated from each other by the through-insulation structure TSa. For example, the through-insulation structure TSa may penetrate through a portion of the lower gate stack region GS_L, such that portions of one lower gate layer among the lower gate layers 35g positioned on opposite sides of the through-insulation structure TSa may be electrically connected to each other.

The structure ST may further include a vertical memory structure VS that extends through the stack structure SS in the memory cell array region MCA.

The semiconductor device 1aa may further include a first upper insulating layer 83, a second upper insulating layer 91, and a third upper insulating layer 95, sequentially stacked, on the stack structure SS and the upper capping insulating layer 67.

The semiconductor device 1aa may further include a dam structure 85 extending through the stack structure SS and surrounding the through-insulation region TA.

The separation structures WLC may extend through the first upper insulating layer 83 and the stack structure SS, and may extend into the conductive plate structure PS.

In some embodiments, the separation structures WLC may be formed of an insulating material.

In some embodiments, each of the separation structures WLC may include a conductive pattern and an insulating spacer that covers a side surface of the conductive pattern. Here, the conductive pattern may be in contact with the lower layer 18 of the conductive plate structure PS.

The semiconductor device 1aa may further include gate contact plugs 93g, each electrically connected to one of the lower and upper gate layers 35g and 59g, in the extension region EA. For example, the gate contact plugs 93g may be in contact with the gate pads GP on the gate pads GP. The gate contact plugs 93g may extend through the first and second upper insulating layers 83 and 91 and the capping structure 69, and may be in contact with the gate pads GP.

The semiconductor device 1aa may further include a source contact plug 93s that extends through the first and second upper insulating layers 83 and 91 and the capping structure 69, and the source contact plug 93s may be in contact with the lower layer 18 of the conductive plate structure PS.

The semiconductor device 1aa may further include first through-contact plugs 93c1 that extend through the first and second upper insulating layers 83 and 91, the capping structure 69, the through-insulation structure TSa, and the gap-fill insulating layer 28a and may be electrically connected to the peripheral circuit wiring 12. The semiconductor device 1aa may further include second through-contact plugs 93c2 that extend through the first and second upper insulating layers 83 and 91, the capping structure 69, and the intermediate insulating layer 28b and may be electrically connected to the peripheral circuit wiring 12.

The semiconductor device 1aa may further include a bit line contact plug 97b on the vertical memory structure VS, a first gate connection plug 97g1 on the first through-contact plug 93c1, second gate connection plugs 97g2 on the gate contact plugs 93g, a source connection plug 97s on the source contact plug 93s, and a peripheral connection plug 97p on the second through-contact plug 93c2.

The semiconductor device 1aa may further include bit lines BL, a gate connection wiring 99g, a source connection wiring 99s, and a peripheral connection wiring 99p, on the third upper insulating layer 95. The bit lines BL may be electrically connected to the vertical memory structures VS through the bit line contact plug 97b. The gate connection wiring 99g may be electrically connected to the first and second gate connection plugs 97g1 and 97g2. The source connection wiring 99s may be electrically connected to the source connection plug 97s, and the peripheral connection wiring 99p may be electrically connected to the peripheral connection plug 97p.

Subsequently, a cross-sectional structure of a region indicated by "A" in FIG. 2A will be described with reference to FIG. 2C.

As seen in FIG. 2C, the vertical memory structure VS may include an insulating core region 79, a channel layer 77 covering side and bottom surfaces of the insulating core region 79, a data storage structure 75 covering outer and bottom surfaces of the channel layer 77, and a pad pattern 81 in contact with the channel layer 77 on the insulating core region 79.

The data storage structure 75 may include a first dielectric layer 75a, a second dielectric layer 75c, and a data storage layer 75b between the first dielectric layer 75a and the second dielectric layer 75c. The second dielectric layer 75c may be in contact with the channel layer 77. The first dielectric layer 75a may include at least one of silicon oxide and a high-κ dielectric. The second dielectric layer 75c may include silicon oxide or silicon oxide doped with impurities. The data storage layer 75b may include a material capable of storing data by trapping a charge, for example, silicon nitride. The data storage layer 75b may have regions in which a semiconductor device such as a flash memory or a variable resistance memory may be capable of storing data.

The pad pattern 81 may include at least one of doped polysilicon, a metal nitride (for example, TiN or the like), a metal (for example, W or the like), and a metal-semiconductor compound (for example, TiSi or the like). The channel layer 77 may include a silicon layer. The insulating core region 79 may include silicon oxide. The first intermediate layer 22a may extend through the data storage structure 75, and may be in contact with the channel layer 77. Accordingly, the data storage structure 75 may be isolated into a lower portion 77L and an upper portion 75U by the first intermediate layer 22a.

The vertical memory structure VS may include a lower vertical portion 73L extending through the lower gate stack region GS_L, an upper vertical portion 73U extending through the upper gate stack region GS_U, and a slope change portion 73V formed by a slope difference between the lower vertical portion 73L and the upper vertical portion 73U. An upper side surface of the lower vertical portion 73L and a lower side surface of the upper vertical portion 73U may not be vertically aligned. Accordingly, the slope change portion 73V may also be referred to as a bent portion of a side surface of the vertical memory structure VS.

In the above-described example embodiment, the first memory blocks MB1a and the second memory blocks MB2a may extend in directions, perpendicular to each other, thereby minimizing warpage of the semiconductor device 1aa. Accordingly, defects of the semiconductor device 1aa caused by warpage may be prevented, and the semiconductor device 1aa may have improved reliability due to the minimized warpage.

In addition, since the warpage is minimized, the number of the gate layers 35g and 59g stacked in the first and second memory blocks MB1a and MB2a may be increased. Accordingly, a degree of integration of the semiconductor device 1aa may be increased.

Hereinafter, various modifications of elements of the above-described example embodiment will be described. The various modifications of the elements of the above-described example embodiment described below will mainly be described with respect to elements to be modified or elements to be replaced. In addition, the elements that are modifiable or replaceable to be described below are described with reference to drawings below, but the elements that are modifiable or replaceable may be combined with each other, and/or may be combined with the elements described above to configure a semiconductor device according to example embodiments.

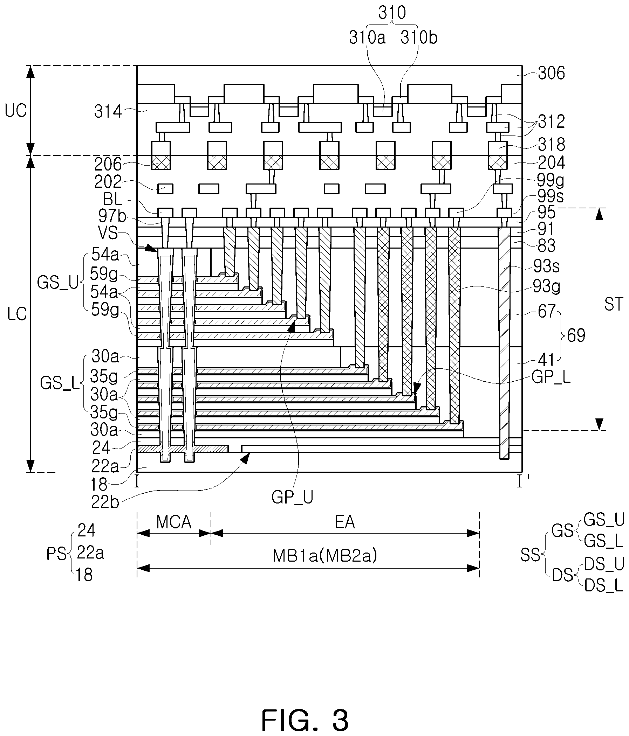

In the example embodiment described above with reference to FIGS. 2A to 2C, a peripheral circuit of the peripheral circuit structure 3 may vertically overlap the structure ST, and the conductive plate structure PS may be between the structure ST and the peripheral circuit structure 3, but the present disclosure is not limited thereto. For example, the peripheral circuit of the peripheral circuit structure 3 may be on the structure ST, and the structure ST may be modified to be between the conductive plate structure PS and the peripheral circuit structure 3. Such a modification will be described with reference to FIG. 3.

In some example embodiments, referring to FIG. 3, the semiconductor device 1aa may include a lower chip structure LC and an upper chip structure UC in contact with the lower chip structure LC.

The lower chip structure LC may include structures from the conductive plate structure PS described above to the bit line BL, the source connection wiring 99s, and the gate connection wiring 99g. For example, the structure may include the structure ST including the stack structure SS, the vertical memory structure VS, and the bit lines BL described above with reference to FIGS. 2A to 2C.

In some embodiments, the lower chip structure LC may not include the through-insulation region TA and the dam structure 85 described with reference to FIG. 2A.

The lower chip structure LC may further include an insulating structure 204 on the third upper insulating layer 95, a connection wiring 202 in the insulating structure 204, and lower bonding pads 206 coplanar with an upper surface of the insulating structure 204.

The upper chip structure UC may include a substrate 306, peripheral circuits 310 below the substrate 306, a peripheral circuit wiring 312 electrically connected to the peripheral circuits 310 below the peripheral circuits 310, an insulating structure 314 covering the peripheral circuits 310 and the peripheral circuit wiring 312 below the substrate 306, and upper bonding pads 318 having a lower surface coplanar with a lower surface of the insulating structure 314 in the insulating structure 314. The peripheral circuits 310 may include a transistor including a peripheral gate 310a and a peripheral source/drain 310b.

The lower chip structure LC may be bonded to the upper chip structure UC. For example, the insulating structure 204 of the lower chip structure LC and the insulating structure 314 of the upper chip structure UC may be bonded to each other while being in contact with each other, and the lower bonding pads 206 and the upper bonding pads 318 may be bonded to each other while being in contact with each other.

The lower bonding pads 206 and the upper bonding pads 318 may include the same metal material, for example, copper.

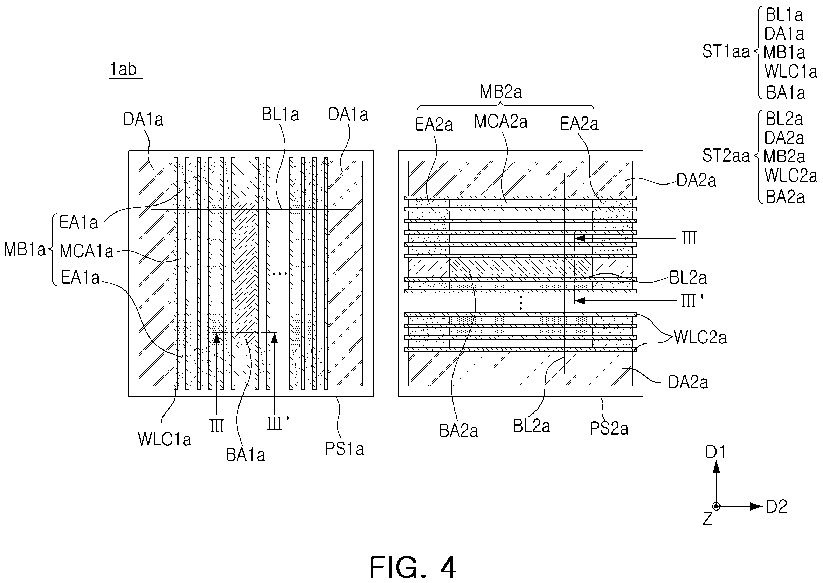

Subsequently, referring to FIG. 4, a modification of a semiconductor device according to some example embodiments will be described. FIG. 4 is a schematic plan view illustrating a modification of a semiconductor device according to some example embodiments.

In a modification, referring to FIG. 4, the first structure ST1a described with reference to FIG. 1 may be modified into a first structure ST1aa further including a first bit line connection region BA1a, and the second structure ST2a described with reference to FIG. 1 may be modified to be a second structure ST2aa further including a second bit line connection region BA2a. Accordingly, a semiconductor device 1ab including the first and second structures ST1aa and ST2aa may be provided.

The first bit line connection region BA1a may be between the first memory blocks MB1a described with reference to FIG. 1. The first bit line connection region BA1a may be spaced apart from the first memory blocks MB1a by the first separation structures WLC1a.

The second bit line connection region BA2a may be between the second memory blocks MB2a described with reference to FIG. 1. The second bit line connection region BA2a may be spaced apart from the second memory blocks MB2a by the second separation structures WLC2a.

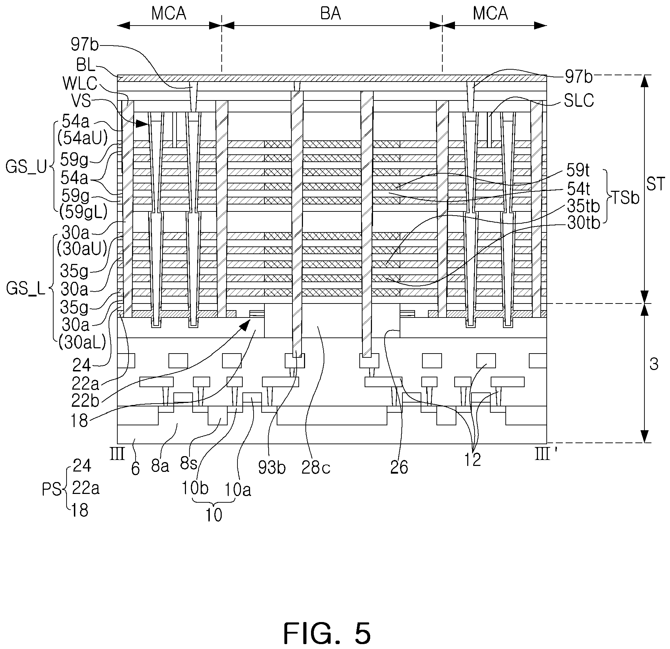

As described above, a cross-sectional structure of the first structure ST1aa in the first horizontal direction D1 and a cross-sectional structure of the second structure ST2aa in the second horizontal direction D2 may be substantially the same. A cross-sectional structure of the first structure ST1aa in the second horizontal direction D2 and a cross-sectional structure of the second structure ST2aa in the first horizontal direction D1 may be substantially the same. Hereinafter, some examples of cross-sectional structures of the first and second bit line connection regions BA1a and BA2a will be described with reference to FIG. 5. That is, in FIG. 4, a cross-sectional structure of the first structure ST1aa taken along line III-III' and a cross-sectional structure of the second structure ST2aa taken along line III-III' will be described with reference to FIG. 5.

Referring to FIGS. 4 and 5, a region indicated by "BA" in FIG. 5 may be the first bit line connection region BA1a or the second bit line connection region BA2a in FIG. 4, and will be referred to as a "bit line connection region" herein. In FIG. 5, a region indicated by "ST" may be the first structure ST1aa or the second structure ST2aa in FIG. 4, and will be referred to as a "structure" herein.

The conductive plate structure PS may have an opening 26 in the bit line connection region BA, and a gap-fill insulating layer 28c may be in the opening 26.

The structure ST may further include a through-insulation structure TSb vertically overlapping the gap-fill insulating layer 28c in the bit line connection region BA. The through-insulation structure TSb may include interlayer insulating layers 30tb and 54t and horizontal insulating layers 35tb and 59t. The horizontal insulating layers 35tb and 59t may be on a level the same as that of the gate layers 35g and 59g.

Bit line through-contact plugs 93b may extend through through-insulation structure TSb and the gap-fill insulating layer 28c and may electrically connect the bit lines BL and the peripheral circuit wiring 12 of the peripheral circuit structure 3 to each other. The bit line through-contact plugs 93b may be signal paths electrically connecting the bit lines BL and the peripheral circuit 10 to each other.

A string isolation pattern SLC may be across one of the gate layers 35g and 59g or the plurality of upper gate layers 59g. Among the gate layers 35g and 59g, one or more upper gate layers 59g may be string selection gate lines and/or upper erasure control gate lines. Among the gate layers 35g and 59g, one or more lower gate layers 35g may be lower selection gate lines and/or lower erasure control gate lines. Among the gate layers 35g and 59g, intermediate gate layers may be word lines.

Among the gate layers 35g and 59g in the first memory blocks (MB1a in FIG. 1), intermediate gate layers may be first word lines. Among the gate layers 35g and 59g in the second memory blocks (MB2a in FIG. 1), intermediate gate layers may be second word lines on a level the same as that of the first word lines.

Each of the first word lines of the first memory blocks (MB1a in FIG. 1) may extend in the first horizontal direction D1, and each of the second word lines of the second memory blocks (MB2a in FIG. 1) may extend in the second horizontal direction D2.

Among the vertical memory structures VS, vertical memory structures in the first memory blocks (MB1a in FIG. 1) may be referred to as first vertical memory structures extending through the first word lines, and vertical memory structures in the second memory blocks (MB2a in FIG. 1) may be referred to as second vertical memory structures extending through the second word lines.

The first vertical memory structures VS in the first memory blocks (MB1a in FIG. 1) may be electrically connected to the first common source of the first conductive plate structure PS1a, for example, the first intermediate layer (22a in FIGS. 2A and 2C), and the first vertical memory structures VS in the second memory blocks (MB2a in FIG. 1) may be electrically connected to the second common source of the second conductive plate structure PS2a, for example, the first intermediate layer (22a in FIGS. 2A and 2C).

In the above-described example embodiment, a first peripheral circuit 10, electrically connected to the bit lines BL through the bit line through-contact plugs 93b and the peripheral circuit wiring 12, may be included in a page buffer circuit region, and a second peripheral circuit 10, electrically connected to the gate layers 35g and 59g through the gate connection wiring 99g, the gate contact plugs 93g, and the peripheral circuit wiring 12, may be included in a pass transistor circuit region. Here, the bit lines BL may be included in the first bit lines BL1a and the second bit lines BL2a, as illustrated in FIG. 4, and the gate layers 35g and 59g may be included in gate layers of the first memory blocks MB1a and gate layers of the second memory blocks MB2a, as illustrated in FIG. 4.

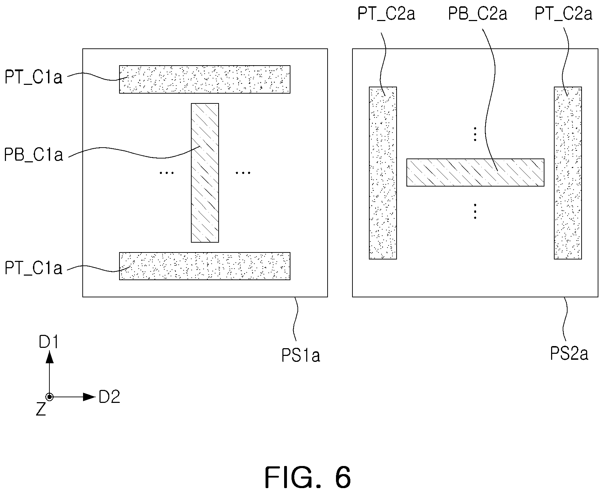

Accordingly, a first peripheral circuit 10 electrically connected to the first bit lines BL1a through the bit line through-contact plugs 93b and the peripheral circuit wiring 12 may be included in a first page buffer circuit region. A second peripheral circuit 10 electrically connected to the second bit lines BL2a through the bit line through-contact plugs 93b, and the peripheral circuit wiring 12 may be included in a second page buffer circuit region. A third peripheral circuit 10, electrically connected to the gate layers 35g and 59g of the first memory blocks MB1a through the gate connection wiring 99g, the gate contact plugs 93g, and the peripheral circuit wiring 12, may be included in a first pass transistor circuit region. A fourth peripheral circuit 10, electrically connected to the gate layers 35g and 59g of the second memory blocks MB2a through the gate connection wiring 99g, the gate contact plugs 93g, and the peripheral circuit wiring 12, may be included in a second pass transistor circuit region. Here, the first and second page buffer circuit regions and the first and second pass transistor circuit regions will be described with reference to FIG. 6. FIG. 6 is a plan view illustrating examples of the first and second page buffer circuit regions and the first and second pass transistor circuit regions.

In an example, referring to FIG. 6 together with FIGS. 1 to 5, the first page buffer circuit region PB_C1a including the first peripheral circuit 10 electrically connected to the first bit lines BL1a through the bit line through-contact plugs 93b and the peripheral circuit wiring 12 may have a shape elongated in the first horizontal direction D1, and the second page buffer circuit region PT_C2a including the second peripheral circuit 10 electrically connected to the second bit lines BL2a through the bit line through-contact plugs 93b and the peripheral circuit wiring 12 may have a shape elongated in the second horizontal direction D2.

The first pass transistor circuit region PT_C1a may include the third peripheral circuit 10, electrically connected to the gate layers 35g and 59g of the first memory blocks MB1a through the gate connection wiring 99g, the gate contact plugs 93g, and the peripheral circuit wiring 12. The first pass transistor circuit region PT_C1a may be provided as a pair of first pass transistor circuit regions PT_C1a, spaced apart from each other in the first horizontal direction D1. Each of the pair of first pass transistor circuit regions PT_C1a, spaced apart from each other, may extend in the second horizontal direction D2. The first pass transistor circuit region PT_C1a may have a shape that is elongated in the second horizontal direction D2. The third peripheral circuit 10 of the first pass transistor circuit region PT_C1a may include first pass transistors electrically connected to first word lines of the gate layers 35g and 59g of the first memory blocks MB1a. The first pass transistors may include the peripheral gate 10a and the peripheral source/drain 10b.

The second pass transistor circuit region PT_C2a may include the fourth peripheral circuit 10, electrically connected to the gate layers 35g and 59g of the second memory blocks MB2a through the gate connection wiring 99g, the gate contact plugs 93g, and the peripheral circuit wiring 12. The second pass transistor circuit region PT_C2a may be provided as a pair of second pass transistor circuit regions PT_C2a, spaced apart from each other in the second horizontal direction D2. Each of the pair of second pass transistor circuit regions PT_C2a, spaced apart from each other, may extend in the first horizontal direction D1. The second pass transistor circuit region PT_C2a may have a shape that is elongated in the first horizontal direction D1. The fourth peripheral circuit 10 of the second pass transistor circuit region PT_C2a may include second pass transistors electrically connected to first word lines of the gate layers 35g and 59g of the second memory blocks MB2a. The second pass transistors may include the peripheral gate 10a and the peripheral source/drain 10b.

The first page buffer circuit region PB_C1a may be between the pair of first pass transistor circuit regions PT_C1a, and the second page buffer circuit region PT_C1a may be between the pair of second pass transistor circuit regions PT_C2a.

In some example embodiments, one of the pair of first pass transistor circuit regions PT_C1a may be omitted.

In some example embodiments, one of the pair of second pass transistor circuit regions PT_C2a may be omitted.

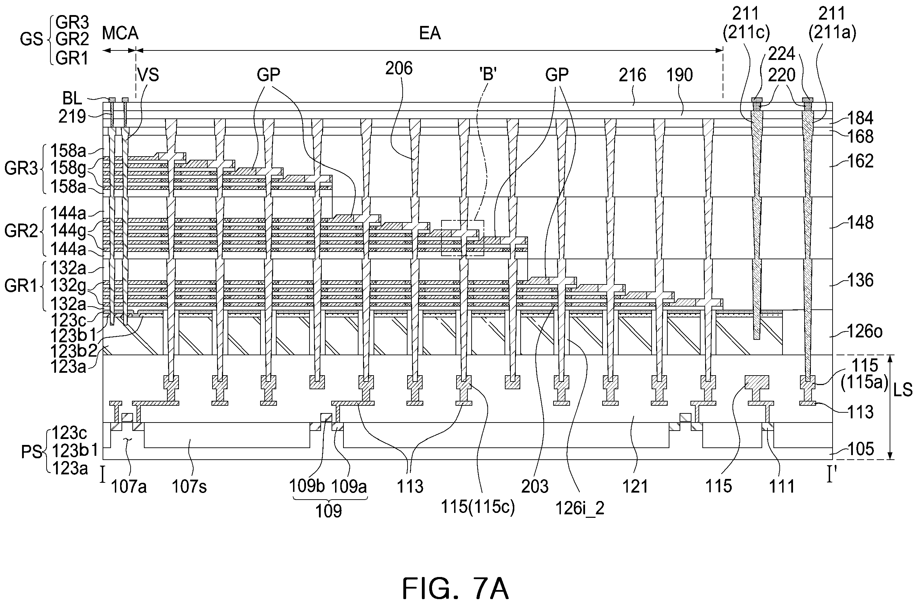

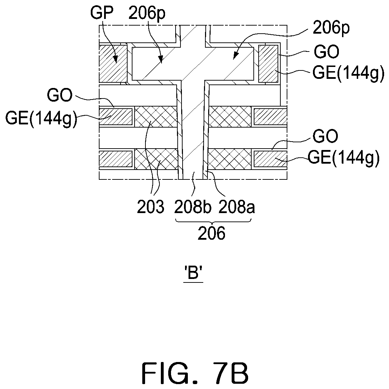

Subsequently, with reference to FIGS. 7A and 7B, a modification of a cross-sectional structure of the semiconductor device 1aa described with reference to FIGS. 1 and 2A will be described. FIG. 7A is a schematic cross-sectional view illustrating a cross-sectional structure of the first structure ST1a taken along line I-I' of FIG. 1 and a cross-sectional structure of the second structure ST2a taken along line I-I'. FIG. 7B is a partially enlarged schematic view illustrating a region indicated by "B" in FIG. 7A. Hereinafter, elements modified from the cross-sectional structure of the semiconductor device 1aa described with reference to FIGS. 1 and 2A will mainly be described.

In a modification, referring to FIGS. 1, 7A and 7B, a lower structure LS corresponding to the lower structure 3 described with reference to FIGS. 2A and 2B may be provided. For example, the lower structure LS may include a substrate 105, device isolation regions 107s that define active regions 107a on the substrate 105, and peripheral circuits 109 on the active regions 107a, peripheral circuit wirings 113 and 115 electrically connected to the peripheral circuits 109 on the peripheral circuits 109, and an insulating structure 121 that covers the peripheral circuits 109 and the peripheral circuit wirings 113 and 115. The peripheral circuits 109 may include a transistor including a peripheral gate 109b and a peripheral source/drain 109a. The substrate 105 may be a semiconductor substrate, for example, a silicon substrate or a compound semiconductor substrate.

A conductive plate structure PS may be on the lower structure LS. The conductive plate structure PS may be the first conductive plate structure PS1a or the second conductive plate structure PS2a described with reference to FIG. 1. An intermediate insulating layer 126o corresponding to the intermediate insulating layer 28b as described with reference to FIG. 2A may be provided.

The conductive plate structure PS may include a lower layer 123a, a first intermediate layer 123b1 on the lower layer 123a, and an upper layer 123c that covers the first intermediate layer 123b1 on the lower layer 123a. The conductive plate structure PS may include at least one doped silicon layer, which may be a common source. For example, at least one of the lower layer 123a, the first intermediate layer 123b1, and the upper layer 123c may include a polysilicon layer having an N-type conductivity. For example, the first intermediate layer 123b1 may be the first common source of the first conductive plate structure PS1a or the second common source of the second conductive plate structure PS2a described with reference to FIG. 1.

A second intermediate layer 123b2 may be on the lower layer 123a, and may be spaced apart in a horizontal direction from the first intermediate layer 123b1. The upper layer 123c may cover the second intermediate layer 123b2. The second intermediate layer 123b2 may be formed of an insulating material.

A stack structure GS may be on the conductive plate structure PS. The stack structure GS may be in a memory cell array region MCA, and may extend into an extension region EA.

The stack structure GS may include at least three stack groups GR1, GR2, and GR3 stacked in the vertical direction Z. For example, the stack structure GS may include a lower stack group GR1, an intermediate stack group GR2 on the lower stack group GR1, and an upper stack group GR3 on the intermediate stack group GR2. The lower stack group GR1 may include lower interlayer insulating layers 132a and lower gate layers 132g, which may be alternately stacked. The intermediate stack group GR2 may include lower interlayer insulating layers 144a and intermediate gate layers 144g, which may be alternately stacked. The upper stack group GR3 may include upper interlayer insulating layers 158a and upper gate layers 158g, which may be alternately stacked.

Each of the lower, intermediate, and upper gate layers 132g, 144g, and 158g may include a first layer GO and a second layer GE. The first layer GO may cover upper and lower surfaces of the second layer GE, and may extend between the memory vertical structure VS and the second layer GE. In some example embodiments, the first layer GO may include a dielectric material, and the second layer GE may include a conductive material. For example, the first layer GO may include a high-κ dielectric such as AlO or the like, and the second layer GE may include a conductive material such as TiN, WN, Ti, W, or the like. In another example, the first layer GE may include a first conductive material (for example, TiN, W, or the like), and the second layer GE may include a second conductive material different from the first conductive material (for example, Ti, W, or the like).

The lower, intermediate, and upper gate layers 132g, 144g, and 158g may include gate pads GP arranged to have a stair shape in the extension region EA. The gate pads GP are not limited to the stair shape illustrated in FIG. 7A and may be arranged to have various types of shapes or various types of stair shapes.

A thickness of each of the gate pads GP may be greater than a thickness of each of the lower, intermediate, and upper gate layers 132g, 144g, and 158g in regions other than the gate pads GP.

Intermediate insulating structures 136, 148, and 162 may cover at least a portion of the stack structure GS. The intermediate insulating structures 136, 148, and 162 may include a first intermediate insulating layer 136 that covers the gate pads GP of the lower gate layers 132g on the lower structure LS, a second intermediate insulating layer 148 that covers the gate pads GP of the intermediate gate layers 144g on the first intermediate insulating layer 136, and a third intermediate insulating layer 162 that covers the gate pads GP of the upper gate layers 158g on the second intermediate insulating layer 148.

Upper insulating structures 168, 184, 190, and 216 on the stack structure GS in addition to the intermediate insulating structures 136, 148, and 162 may be further included. The intermediate insulating structures 136, 148, and 162 and the upper insulating structures 168, 184, 190, and 216 may be included in an insulating structure. The upper insulating structures 168, 184, 190, and 216 may include a first upper insulating layer 168, a second upper insulating layer 184, a third upper insulating layer 190, and a fourth upper insulating layer 216.

Memory vertical structures VS may extend or pass through at least the stack structure GS in the memory cell array region MCA. Each of the memory vertical structures VS may extend downwardly from a portion that extends through the stack structure GS into the conductive plate structure PS. For example, the memory vertical structures VS may pass through sequentially the upper layer 123c and the first intermediate layer 123b1 and extend into the lower layer 123a, and may be in contact with the lower layer 123a.

Each of the memory vertical structures VS may include the insulating core region 79, the channel layer 77, the data storage structure 75, and the pad pattern 81 described with reference to FIG. 2C. As described with reference to FIG. 2C, the first intermediate layer 123b1, which may be a common source, may pass through the data storage structure (75 in FIG. 2C) and may be in contact with the channel layer 77.

The separation structures WLC1a and WLC2a described with reference to FIG. 1 may pass through at least the stack structure GS.

The peripheral contact plug 211a may be spaced apart from the stack structure GS, and may pass through the intermediate insulating structures 136, 148, and 162, the intermediate insulating layer 126o, and the first, second, and third upper insulating layers 168, 184, and 190. The peripheral contact plug 211a may be in contact with first peripheral pads 115a of the peripheral circuit wirings 113 and 115. A source contact plug 211c may be spaced apart from the stack structure GS, may pass through the first, second, and third upper insulating layers 168, 184, and 190, and may be in contact with the lower layer 123a. Upper surfaces of contact plugs 211 including the source contact plug 211c and the peripheral contact plug 211a may be coplanar with each other.

Gate contact plugs 206 may at least pass through the stack structure GS and may be electrically connected to the gate pads GP of the gate layers 132g, 144g, and 158g. Each of the gate contact plugs 206 may have a lower surface on a level that is lower than that of a lowermost gate layer 132g among the gate layers 132g, 144g, and 158g, and an upper surface that is on a level higher than that of an uppermost gate layer 158g among the gate layers 132g, 144g, and 158g. The gate contact plugs 206 may be in contact with the gate pads GP, respectively. The gate contact plugs 206 may be in contact with the gate pads GP and may pass through the gate pads GP, respectively. For example, one gate contact plug 206 may be in contact with and be electrically connected to one gate pad GP while penetrating through the one gate pad GP. Buffer insulating layers 203 may be between gate layers on a level lower than that of the gate pads GP and the gate contact plugs 206. For example, when viewed with respect to the one gate pad GP and the gate contact plug 206 in contact with each other, the buffer insulating layers 203 may be between gate layers on a level lower than that of the one gate pad GP and the gate contact plug 206. The buffer insulating layers 203 may be formed of silicon oxide. The gate contact plug 206 may include a horizontal extension portion 206p that extends from a portion in contact with the gate pad GP in a horizontal direction. When gate layers are on a level lower than that of the gate pad GP in contact with the gate contact plug 206, the buffer insulating layers 203 may be between the gate layers on a level lower than that of the gate pad GP and the gate contact plugs 206, as described above. The buffer insulating layers 203 may overlap the horizontal extension portion 206p.

The gate contact plugs 206 may extend downwardly and may pass through the conductive plate structure PS, and may be electrically connected to peripheral pads 115c of the peripheral circuit wirings 113 and 115. An insulating pattern 126i_2 may be between the gate contact plugs 206 and the conductive plate structure PS, such that the gate contact plugs 206 and the conductive plate structure PS may be spaced apart from each other.

Bit line contact plugs 219 may be electrically connected to the memory vertical structures VS, and may extend through the upper insulating structures 168, 184, 190, and 216. Upper contact plugs 220 may pass through the fourth upper insulating layer 216 and may be respectively electrically connected to the contact plugs 211. Bit lines VS may be electrically connected to the memory vertical structure VS through the bit line contact plugs 219 on the fourth upper insulating layer 216. Peripheral wirings 224 may be respectively electrically connected to the contact plugs 211 through the contact plugs 220.

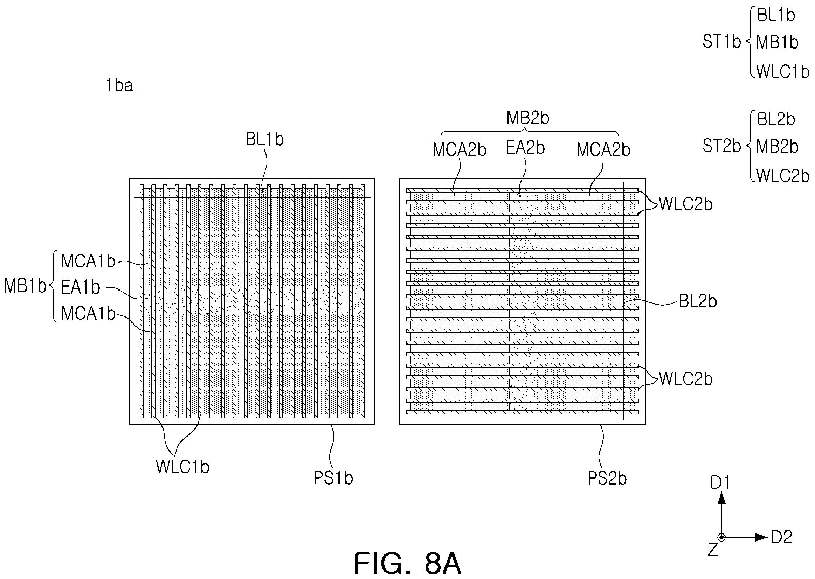

Subsequently, with reference to FIG. 8A, a modification of a semiconductor device according to some example embodiments will be described. FIG. 8A is a schematic plan view illustrating a modification of a semiconductor device according to some example embodiments.

In a modification, referring to FIG. 8A, a semiconductor device 1ba in the modification may include a first conductive plate structure PS1b and a second conductive plate structure PS2b arranged substantially at the same level and spaced apart from each other. The first conductive plate structure PS1b may include a first common source, and the second conductive plate structure PS1b may include a second common source.

The semiconductor device 1ba may further include a first structure ST1b on the first conductive plate structure PS1b and a second structure ST2b on the second conductive plate structure PS2b.

The first structure ST1b may include first memory blocks MB1b and first separation structures WLC1b.

Each of the first memory blocks MB1b may extend in a first horizontal direction D1, parallel to an upper surface of the first conductive plate structure PS1b. Each of the first separation structures WLC1b may extend in the first horizontal direction D1. Each of the first memory blocks MB1b may be between two of the first separation structures WLC1b adjacent to each other in a second horizontal direction D2. The first memory blocks MB1b may be spaced apart from each other by the first separation structures WLC1b in the second horizontal direction D2.

Each of the first memory blocks MB1b may include two first memory cell array regions MCA1b spaced apart from each other in the first horizontal direction D1, and an extension region EA1b between the two first memory cell array regions MCA1b spaced apart from each other in the first horizontal direction D1. The first structure ST1b may further include first bit lines BL1b parallel to each other. Each of the first bit lines BL1b may extend in the second horizontal direction D2. The first bit lines BL1b may cross the first memory cell array regions MCA1b of the first memory blocks MB1b on a level that is higher than that of the first memory blocks MB1b.

The second structure ST2b may include second memory blocks MB2b and second separation structures WLC2b. Each of the second memory blocks MB2b may extend in the second horizontal direction D2. Each of the second separation structures WLC2b may extend in the second horizontal direction D2. Each of the second memory blocks MB2b may be between two of the second separation structures WLC2b adjacent to each other in the first horizontal direction D1. The second memory blocks MB2b may be spaced apart from each other by the second separation structures WLC2b in the first horizontal direction D1.

Each of the second memory blocks MB2b may include two second memory cell array regions MCA2b spaced apart from each other in the second horizontal direction D2, and a second extension region EA2b may be between the two second memory cell array regions MCA2b spaced apart from each other in the second horizontal direction D2.

The second structure ST2b may further include second bit lines BL2b parallel to each other. Each of the second bit lines BL2b may extend in the first horizontal direction D1. The second bit lines BL2b may cross the second memory cell array regions MCA2b of the second memory blocks MB2b on a level higher than that of the second memory blocks MB2b.

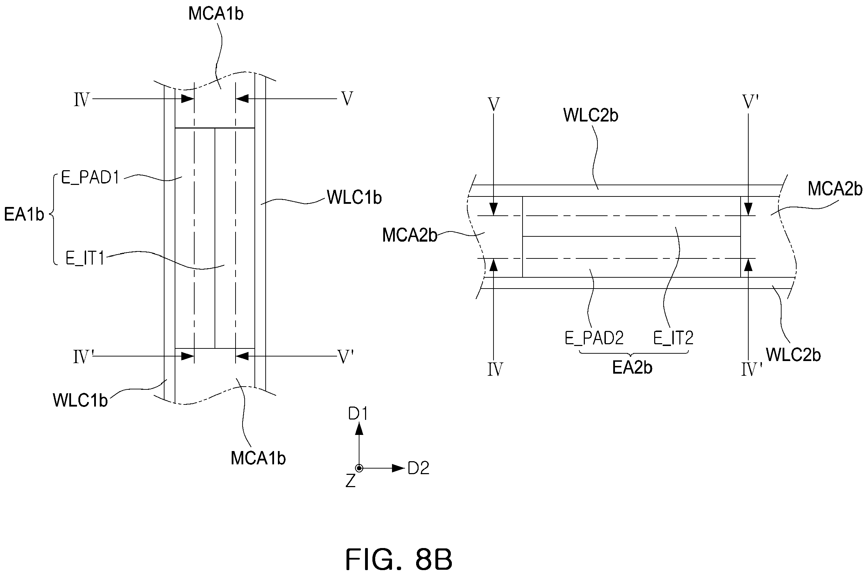

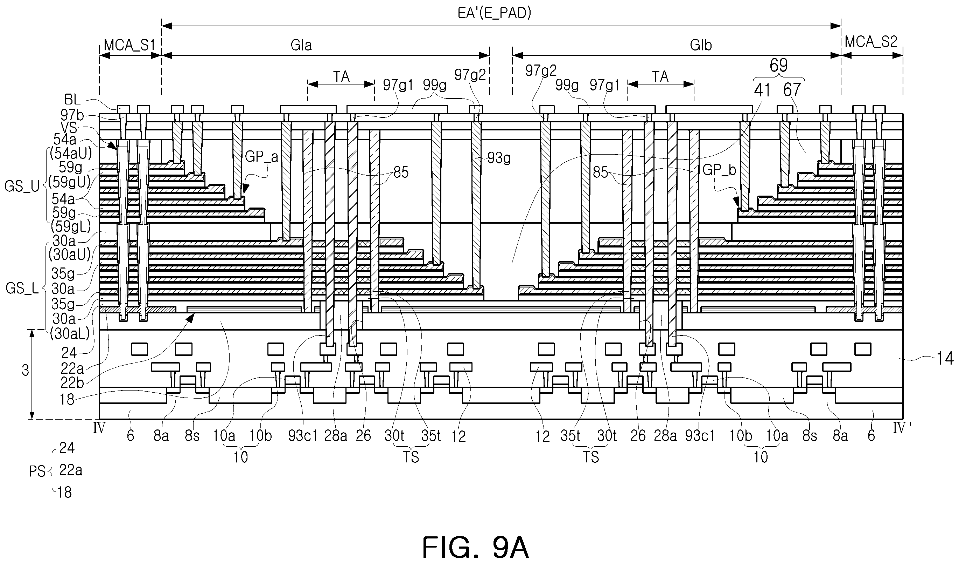

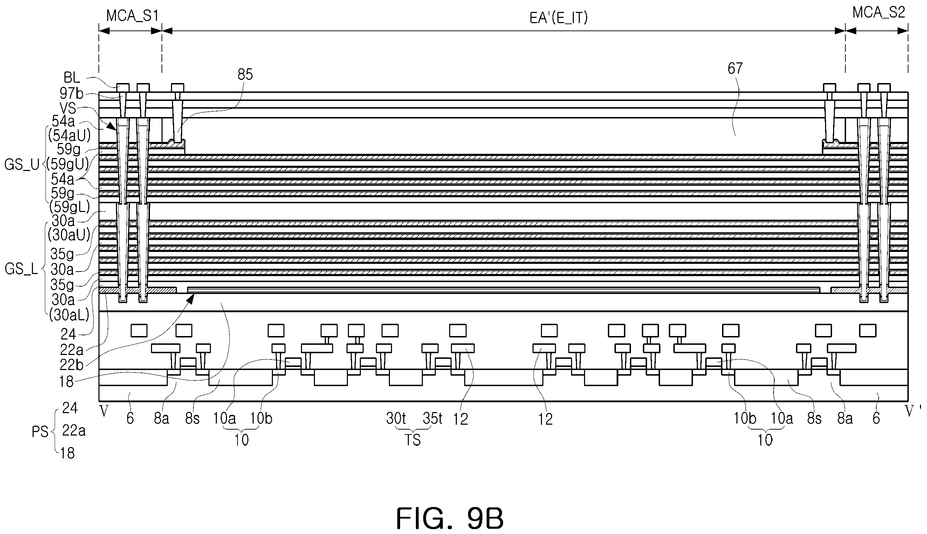

Subsequently, with reference to FIGS. 8B, 9A and 9B, an example of the first and second extension regions EA1b and EA2b and an example of a cross-sectional structure of the semiconductor device 1ba will be described. FIG. 8B is a schematic plan view illustrating an example of the first extension region EA1b between the first memory cell array regions MCA1b and the second extension region EA2b between the second memory cell array regions MCA2b. FIG. 9A is a schematic cross-sectional view illustrating a region taken along line IV-IV' of FIG. 8B. FIG. 9B is a schematic cross-sectional view illustrating a region taken along line V-V' of FIG. 8B. In FIGS. 8B, 9A and 9B, a cross-sectional structure of the first extension region EA1b of the first structure ST1b taken along line IV-IV', and a cross-sectional structure of the second extension region EA2b of the second structure ST2b taken along line IV-IV' may be substantially the same. In FIGS. 8B, 9A and 9B, a cross-sectional structure of the first extension region EA1b of the first structure ST1b taken along line V-V' and a cross-sectional structure of the second extension region EA2b of the second structure ST2b taken along line V-V' may be substantially the same.

Referring to FIGS. 8B, 9A and 9B together with FIG. 8A, the semiconductor device 1ba may further include a lower structure 3. As described with reference to FIG. 2A, the lower structure 3 may include a substrate 6, device isolation regions 8s that define active regions 8a on the substrate 6, peripheral circuits 10 on the active regions 8a, a peripheral circuit wiring 12 electrically connected to the peripheral circuits 10 on the peripheral circuits 10, and an insulating structure 14 covering the peripheral circuits 10 and the peripheral circuit wiring 12. The peripheral circuits 10 may include a transistor including a peripheral gate 10a and a peripheral source/drain 10b. The substrate 6 may be a semiconductor substrate, for example, a silicon substrate or a compound semiconductor substrate.

A conductive plate structure PS may be on the lower structure 3. The conductive plate structure PS may be the first conductive plate structure PS1b or the second conductive plate structure PS2b described with reference to FIG. 8A. The conductive plate structure PS may have an opening 26.

The semiconductor device 1ba may further include a gap-fill insulating layer 28a in the opening 26. The conductive plate structure PS may include the lower layer 18, the first intermediate layer 22a, and the upper layer 24, substantially the same as those described with reference to FIG. 2A. The first intermediate layer 22a of the conductive plate structure PS may be a first common source of the first conductive plate structure PS1b or a second common source of the second conductive plate structure PS2b. The semiconductor device 1ba may further include a second intermediate layer 22b on the lower layer 18 and spaced apart from the first intermediate layer 22a. The upper layer 24 may cover the second intermediate layer 22b.

The first memory cell array regions MCA1b spaced apart from each other in FIGS. 8A and 8B may be referred to as a first-side memory cell array region MCA_S1 and a second-side memory cell array region MCA_S2 spaced apart from each other in FIGS. 9A and 9B. The second memory cell array regions MCA2b spaced apart from each other in FIGS. 8A and 8B may be referred to as the first-side memory cell array region MCA_S1 and the second-side memory cell array region MCA_S2 spaced apart from each other in FIGS. 9A and 9B.

Each of the first and second extension regions EA1b and EA2b in FIG. 8A may include gate pad regions E_PAD1 and E_PAD2 and gate connection regions E_IT1 and E_IT2, as in FIG. 8B. The first and second extension regions EA1b and EA2b in FIGS. 8A and 8B may be referred to as an extension region EA' in FIGS. 9A and 9B. The gate pad regions E_PAD1 and E_PAD2 may be referred to as a gate pad region E_PAD in FIG. 9A. The gate connection regions E_IT1 and E_IT2 in FIGS. 8A and 8B may be referred to as a gate connection region E_IT in FIG. 9B.

In some example embodiments, cross-sectional structures of the first memory cell array regions MCA1b and cross-sectional structures of the second memory cell array regions MCA2b may be substantially the same as a cross-sectional structure of the memory cell array region MCA in FIG. 2A or a cross-sectional structure of the memory cell array region MCA in FIG. 7A. Here, in FIGS. 9A and 9B, an example of a case in which a cross-sectional structure of the first-side memory cell array region MCA_S1 and the second-side memory cell array region MCA_S2 is substantially the same as the cross-sectional structure of the memory cell array region MCA in FIG. 2A will be described. Accordingly, some of the detailed description of the elements described with reference to FIG. 2A will be omitted.

First, referring to FIG. 9A in order to describe a cross-sectional structure of the gate pad region E_PAD, the gate pad region E_PAD may include a first gate pad region GIa adjacent to the first-side memory cell array region MCA_S1 and a second gate pad region GIb adjacent to the second-side memory cell array region MCA_S2.

The gate layers 35g and 59g may include the first and second gate pads GP_a and BP_b extending from the first-side memory cell array region MCA_S1 and the second-side memory cell array region MCA_S2 into the first gate pad region GIa and the second gate pad region GIb to be arranged to have a stair shape in the first and second gate pad regions GIa and GIb. The stair shape may be a "V" shape as illustrated in FIG. 9A, but the example embodiment is not limited thereto and may be modified to have various shapes (e.g., various stair shapes). The gate contact plugs 93g described with reference to FIG. 2A may be in contact with and electrically connected to the gate pads GP_a and GP_b. The through-insulation region TA and the through-contact plugs 93c1 described with reference to FIG. 2A may be disposed in the first and second gate pad regions GIa and GIb.

Subsequently, referring to FIG. 9B in order to describe the cross-sectional structure of the gate connection region E_IT, among the gate layers 35g and 59g, an upper gate layer 59gU in the first-side memory cell array region MCA_S1 and an upper gate layer 59gU in the second-side memory cell array region MCA_S2 may be spaced apart from each other, and gate layers 35g and 59g below the upper gate layer 59gU may extend (e.g., may continuously extend) from the first-side memory cell array region MCA_S1 to the second-side memory cell array region MCA_S2 through the gate connection region E_IT. For example, a word line of one of the gate layers 35g and 59g may be formed as a layer continuously extending throughout the first-side memory cell array region MCA_S1, the gate connection region E_IT, and the second-side memory cell array region MCA_S2, and may have a gate pad in the gate pad region E_PAD.

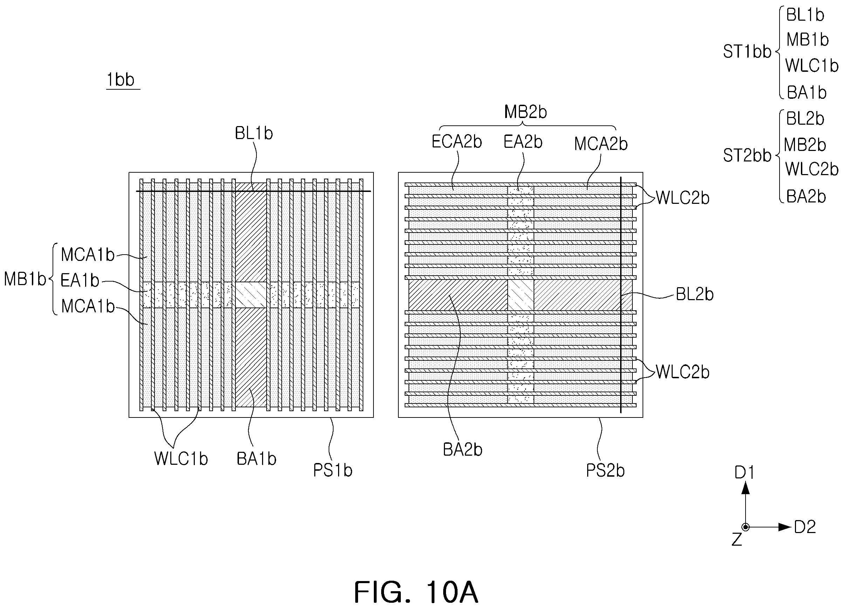

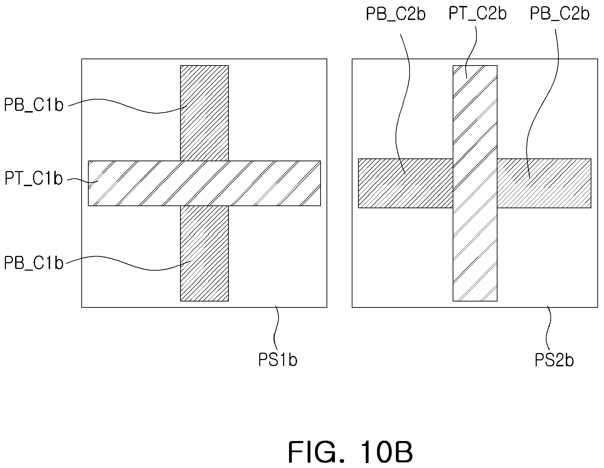

Subsequently, a modification of a semiconductor device according to some example embodiments will be described with reference to FIGS. 10A and 10B. FIGS. 10A and 10B are schematic plan views illustrating a modification of a semiconductor device according to some example embodiment.

In a modification, referring to FIGS. 10A and 10B, the first structure ST1b described with reference to FIG. 8A may be modified to be a first structure ST1bb further including a first bit line connection region BA1b, and the second structure ST2b described with reference to FIG. 8A may be modified to be a second structure ST2bb further including a second bit line connection region BA2b. Accordingly, a semiconductor device 1bb including the first and second structures ST1bb and ST2bb may be provided.

The first bit line connection region BA1b may be between the first memory blocks MB1b described with reference to FIG. 8A. The first bit line connection region BA1b may be spaced apart from the first memory blocks MB1b by the first separation structures WLC1b.

The second bit line connection region BA2b may be between the second memory blocks MB2b described with reference to FIG. 8A. The second bit line connection region BA2b may be spaced apart from the second memory blocks MB2b by the second separation structures WLC2b.

Cross-sectional structures of the first and second bit line connection regions BA1b and BA2b may be substantially the same as cross-sectional structures of the first and second bit line connection regions BA1a and BA2a described with reference to FIGS. 4 and 5.

A first peripheral circuit (e.g., the peripheral circuit 10 in FIGS. 9A and 9B), electrically connected to the first bit lines BL1b through the first bit line connection region BA1b, may be included in first page buffer circuit regions PB_C1b, and a second peripheral circuit (e.g., the peripheral circuit 10 in FIGS. 9A and 9B), electrically connected to the second bit lines BL2b through the second bit line connection region BA2b, may be included in second page buffer circuit regions PB_C2b. A third peripheral circuit (e.g., the peripheral circuit 10 in FIGS. 9A and 9B) electrically connected to the gate layers (35g and 59g in FIGS. 9A and 9B) of the first memory blocks MB1b through the gate connection wiring 99g, the gate contact plugs 93g, and the peripheral circuit wiring 12 may be included in a first pass transistor circuit region PT_C1b. A fourth peripheral circuit (e.g., the peripheral circuit 10 in FIGS. 9A and 9B), electrically connected to the gate layers (35g and 59g in FIGS. 9A and 9B) of the second memory blocks MB2b through the gate connection wiring 99g, the gate contact plugs 93g, and the peripheral circuit wiring 12, may be included in a second pass transistor circuit region PT_C2b.

The first page buffer circuit regions PB_C1b may vertically overlap the first bit line connection region BA1b. The second page buffer circuit regions PT_C2b may vertically overlap the second bit line connection region BA2b. Each of the first page buffer circuit regions PB_C1b may have a shape that is elongated in the first horizontal direction D1, and each of the second bit lines BL2b and the second page buffer circuit regions PT_C2b may have a shape that is elongated in the second horizontal direction D2.

The first pass transistor circuit region PT_C1b including the third peripheral circuit (10 in FIGS. 9A and 9B), which may be electrically connected to the gate layers (35g and 59g in FIGS. 9A and 9B) of the first memory blocks MB1b through the gate connection wiring 99g, the gate contact plugs 93g, and the peripheral circuit wiring 12, may have a shape that is elongated in the second horizontal direction D2. The second pass transistor circuit region PT_C2b including the fourth peripheral circuit (10 in FIGS. 9A and 9B), which may be electrically connected to the gate layers (35g and 59g in FIGS. 9A and 9B) of the second memory blocks MB2b through the gate connection wiring 99g, the gate contact plugs 93g, and the peripheral circuit wiring 12, may have a shape that is elongated in the first horizontal direction D1.

The first pass transistor circuit region PT_C1b may vertically overlap the first extension region EA1b. The second pass transistor circuit region PT_C2b may vertically overlap the second extension region EA2b.

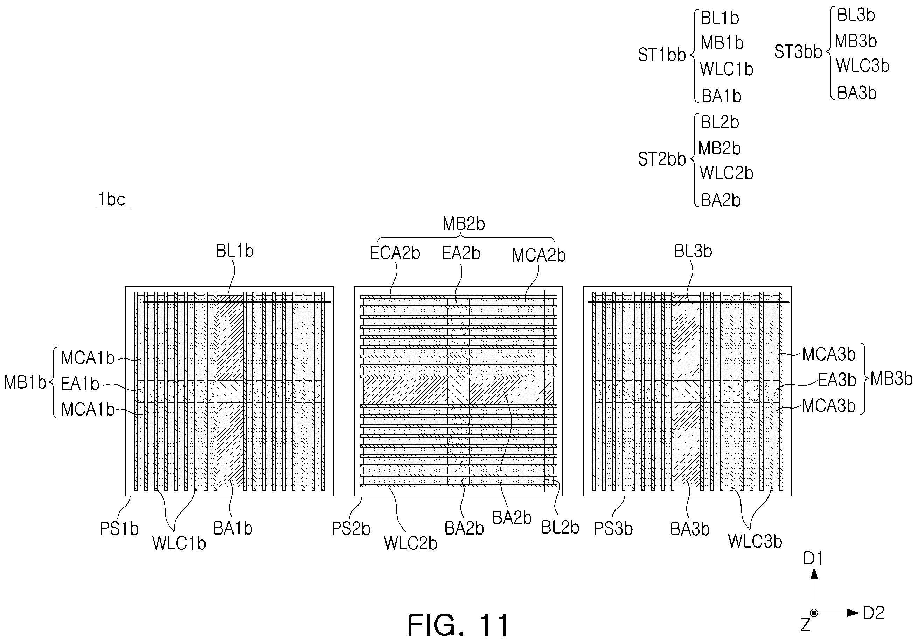

Subsequently, various modifications of the semiconductor device according to an example embodiment will be described with reference to FIGS. 11 to 16, respectively. FIGS. 11 to 16 are schematic plan views illustrating various modifications of a semiconductor device according to some example embodiments. Hereinafter, a plan view of the semiconductor device will be mainly described, and a cross-sectional structure thereof may be described based on the above-described example embodiments.

In a modification, referring to FIG. 11, the semiconductor device 1bb described with reference to FIG. 10A may be modified to be a semiconductor device 1bc further including a third conductive plate structure PS3b and a third structure ST3bb, as illustrated in FIG. 11. The second conductive plate structure PS2b may be between the first conductive plate structure PS1b and the third conductive plate structure PS3b. The first to third conductive plate structures PS1b, PS2b, and PS3b may be substantially at the same level.

Hereinafter, conductive plate structures indicated by different reference numerals may be substantially at the same level and formed of the same material layers.

The third conductive plate structure PS3b and the third structure ST3bb may have a planar shape and a cross-sectional structure substantially the same as those of the first conductive plate structure PS1b and the first structure ST1bb. For example, the third structure ST3bb may include third memory blocks MB3b, the third separation structures WLC3b, and a third bit line connection region BA3b respectively corresponding to the first memory blocks MB1b, the first separation structures WLC1b, and the first bit line connection region BA1b of the first structure ST1bb.

Each of the third memory blocks MB3b may include third memory cell array regions MCA3b and a third extension region EA3b respectively corresponding to the first memory cell array regions MCA1b and the first extension region EA1b of the first memory blocks MB1b. The third memory cell array regions MCA3b may have a structure and a shape that is the same as those of the first memory cell array regions MCA1b, and the third extension region EA3b may have a structure and a shape the same as those of the first extension region EA1b.

Hereinafter, the phrase "A corresponds to B" or "B corresponds to A" may mean that A and B are at the same level, and have the same cross-sectional structure and the same planar shape at the same level. For example, in the phrase "the third memory blocks MB3b corresponding to the first memory blocks MB1b," the first and third memory blocks MB1b and MB3b may be understood as including word lines at the same level and extending in the same direction as each other and vertical memory structures having the same structure.

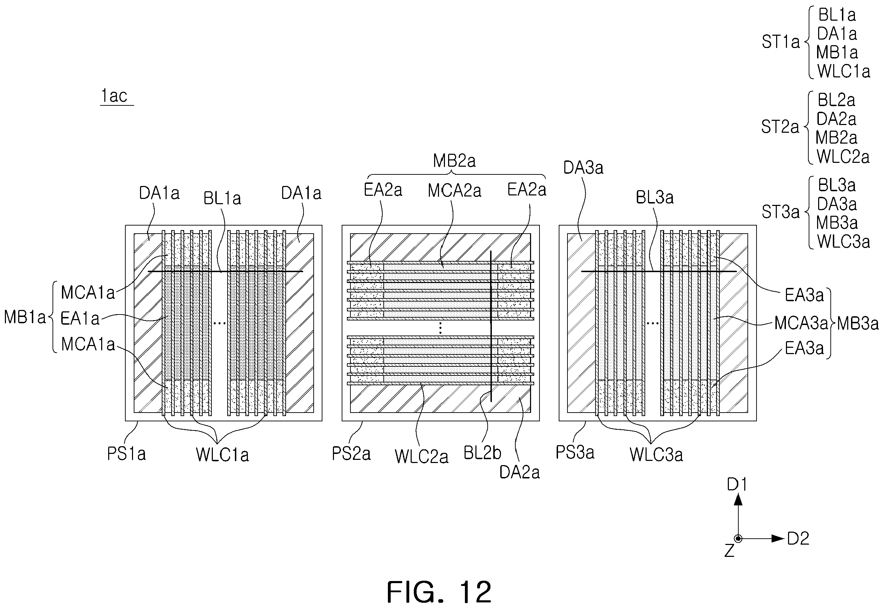

In a modification, referring to FIG. 12, the semiconductor device 1aa described with reference to FIG. 1 may be modified to be a semiconductor device 1ac further including a third conductive plate structure PS3a and a third structure ST3a, as illustrated in FIG. 12. The second conductive plate structure PS2a may be between the first conductive plate structure PS1a and the third conductive plate structure PS3a.

The third conductive plate structure PS3a and the third structure ST3a may have a planar shape and a cross-sectional structure that are substantially the same as those of the first conductive plate structure PS1a and the first structure ST1a. For example, the third structure ST3a may include third memory blocks MB3a, the third separation structures WLC3a, a third bit line connection region BA3a, and a third dummy region DA3a respectively corresponding to the first memory blocks MB1a, the first separation structures WLC1a, the first bit line connection region BA1a, and the first dummy region DA1a of the first structure ST1a.

Each of the third memory blocks MB3a may include a third memory cell array region MCA3a and the third extension regions EA3a respectively corresponding to the first memory cell array region MCA1a and the first extension regions EA1a of the first memory blocks MB1a.

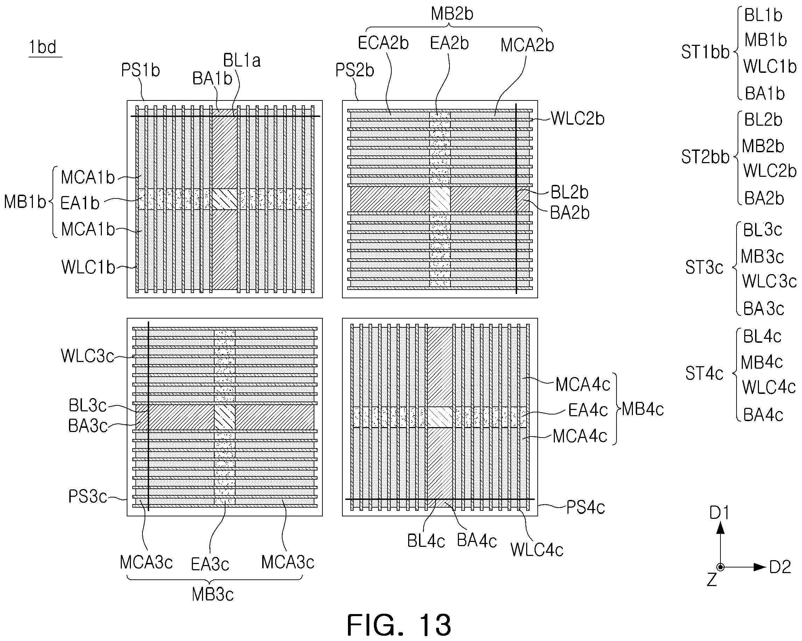

In a modification, referring to FIG. 13, the semiconductor device 1bb described with reference to FIG. 10A may be modified to be a semiconductor device 1bd further including a third conductive plate structure PS3c, a fourth conductive plate structure PS4c, a third structure ST3c, and a fourth structure ST4c.

When viewed in a plan view, the third conductive plate structure PS3c may be below the first conductive plate structure PS1b, and the fourth conductive plate structure PS4c may be below the second conductive plate structure PS2b.

The first and third conductive plate structures PS1b and PS3c may be adjacent to each other in the first horizontal direction D1. The first and second conductive plate structures PS1b and PS2b may be adjacent to each other in the second horizontal direction D2. The third and fourth conductive plate structures PS3c and PS4c may be adjacent to each other in the second horizontal direction D2. The second and fourth conductive plate structures PS2b and PS4c may be adjacent to each other in the first horizontal direction D1.

The third conductive plate structure PS3c and the third structure ST3c may have a planar shape and a cross-sectional structure that are substantially the same as those of the second conductive plate structure PS2b and the second structure ST2bb. For example, the third structure ST3c may include third memory blocks MB3c, third separation structures WLC3c, a third bit line connection region BA3c, and third bit lines BL3b respectively corresponding to the second memory blocks MB2b, the second separation structures WLC2b, the second bit line connection region BA2b, and the second bit lines BL2b of the second structure ST2bb. Each of the third memory blocks MB3c may include third memory cell array regions MCA3c and a third extension region EA3c respectively corresponding to the second memory cell array regions MCA2b and the second extension region EA2b of each of the second memory blocks MB2b.

The fourth conductive plate structure PS4c and the fourth structure ST4c may have a planar shape and a cross-sectional structure that are substantially the same as those of the first conductive plate structure PS1b and the first structure ST1bb. For example, the fourth structure ST4c may include fourth memory blocks MB4c, the fourth separation structures WLC4c, a fourth bit line connection region BA4c, and fourth bit lines BL4a respectively corresponding to the first memory blocks MB1b, the first separation structures WLC1b, the first bit line connection region BA1b, and the first bit lines BL1b of the first structure ST1bb. Each of the fourth memory blocks MB4c may include fourth memory cell array regions MCA4c and a fourth extension region EA4c respectively corresponding to the first memory cell array regions MCA1b and the first extension region EA1b of each of the first memory blocks MB1b.

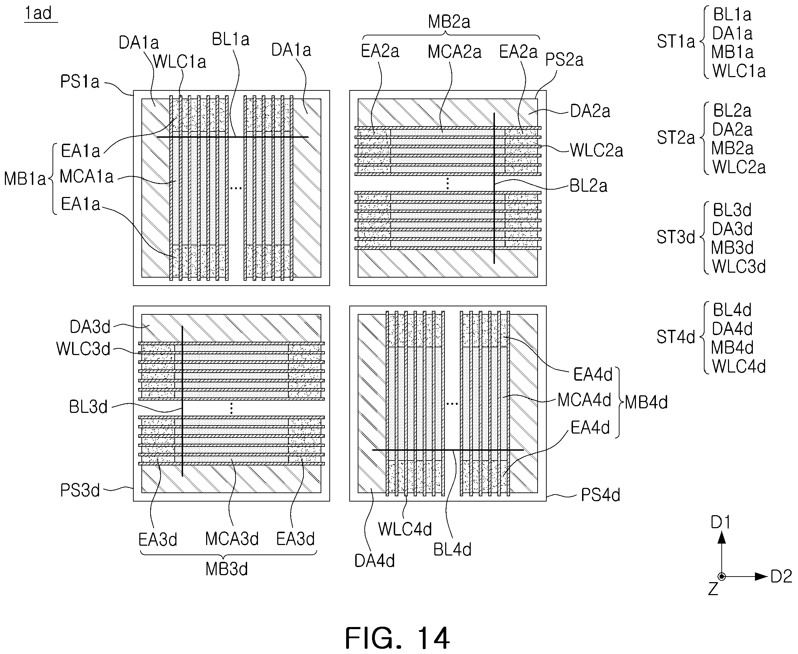

In a modification, referring to FIG. 14, the semiconductor device 1aa described with reference to FIG. 1 may be modified into a semiconductor device 1ad further including a third conductive plate structure PS3d, a fourth conductive plate structure PS4d, a third structure ST3d, and a fourth structure ST4d.

When viewed in a plan view, the third conductive plate structure PS3d may be disposed below the first conductive plate structure PS1a, and the fourth conductive plate structure PS4d may be below the second conductive plate structure PS2a.

The first and third conductive plate structures PS1a and PS3d may be adjacent to each other in the first horizontal direction D1. The first and second conductive plate structures PS1a and PS2a may be adjacent to each other in the second horizontal direction D2. The third and fourth conductive plate structures PS3d and PS4d may be adjacent to each other in the second horizontal direction D2. The second and fourth conductive plate structures PS2a and PS4d may be adjacent to each other in the first horizontal direction D1.

The third conductive plate structure PS3d and the third structure ST3d may have a planar shape and a cross-sectional structure that are substantially the same as those of the second conductive plate structure PS2a and the second structure ST2a. For example, the third structure ST3d may include third memory blocks MB3d, the third separation structures WLC3d, and a third dummy region DA3d respectively corresponding to the second memory blocks MB2a, the second separation structures WLC2a, and the second dummy region DA2a of the second structure ST2a. Each of the third memory blocks MB3d may include a third memory cell array region MCA3d and third extension regions EA3d respectively corresponding to the second memory cell array region MCA2a and the second extension regions EA2a of the second memory blocks MB2a.

The fourth conductive plate structure PS4d and the fourth structure ST4d may have a planar shape and a cross-sectional structure that are substantially the same as those of the first conductive plate structure PS1a and the first structure ST1a. For example, the fourth structure ST4d may include fourth memory blocks MB4d, the fourth separation structures WLC4d, and a fourth dummy region DA4d respectively corresponding to the first memory blocks MB1a, the first separation structures WLC1a, and the first dummy region DA1a of the first structure ST1a. Each of the fourth memory blocks MB4d may include a fourth memory cell array region MCA4d and fourth extension regions EA4d respectively corresponding to the first memory cell array region MCA1a and the first extension regions EA1a of each of the first memory blocks MB1a.

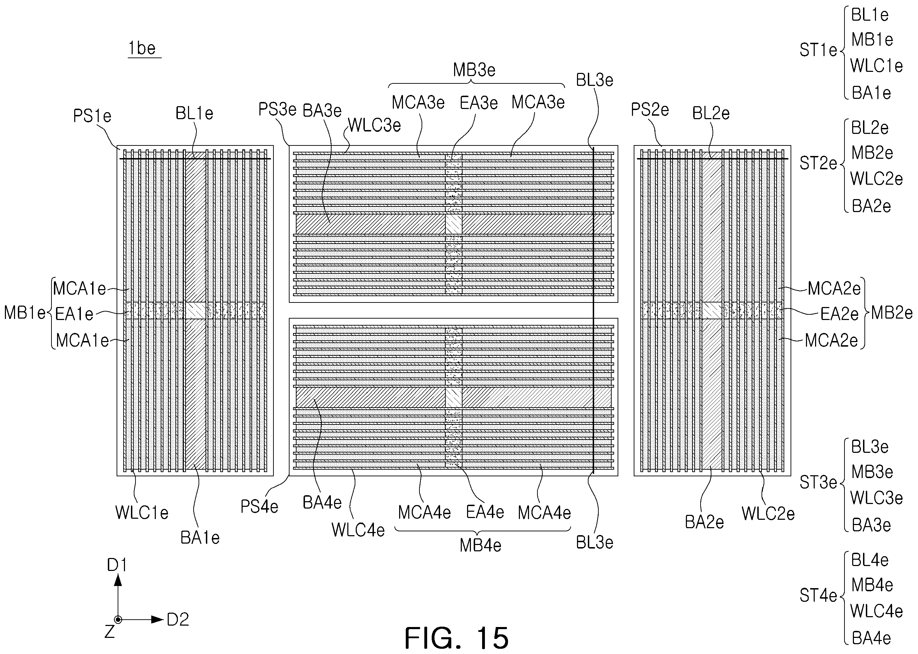

In a modification, referring to FIG. 15, a semiconductor device The in the modification may include the first to fourth conductive plate structures PS1e, PS2e, PS3e, and PS4e spaced apart from each other, and the first to fourth structures ST1e, ST2e, ST3e, and ST4e spaced apart from each other.

The first and second conductive plate structures PS1e and PS2e may be spaced apart from each other in the second horizontal direction D2, may have the same planar shape, and may include the same material layers. The third and fourth conductive plate structures PS3e and PS4e may be between the first and second conductive plate structures PS1e and PS2e, may be spaced apart from each other in the first horizontal direction D1, may have the same planar shape, and may include the same material layers.

Each of the first and second conductive plate structures PS1e and PS2e may have a shape in which the first conductive plate structure PS1b in FIG. 8A is elongated in the first horizontal direction D1, and each of the third and fourth conductive plate structures PS3e and PS4e may have a shape in which the second conductive plate structure PS2b in FIG. 8A is elongated in the second horizontal direction D2. Accordingly, each of the first to fourth conductive plate structures PS1e, PS2e, PS3e, and PS4e may include material layers substantially the same as material layers 18, 22a, and 22a of the conductive plate structure (PS in FIG. 9A), as illustrated in FIGS. 9A and 9B. Each of the first to fourth conductive plate structures PS1e, PS2e, PS3e, and PS4e may include a common source, and common sources of the first to fourth conductive plate structures PS1e, PS2e, PS3e, and PS4e may be spaced apart from each other.

The first structure ST1e may include first memory blocks MB1e, first separation structures WLC1e, and first bit lines BL1e respectively corresponding to the first memory blocks MB1b, the first separation structures WLC1b, and the first bit lines BL1b of the first structure ST1b in FIG. 8A. The second structure ST2e may include second memory blocks MB2e, second separation structures WLC2e, and second bit lines BL2e respectively corresponding to the first memory blocks MB1b, the first separation structures WLC1b, and the first bit lines BL1b of the first structure ST1b in FIG. 8A. The third structure ST3e may include third memory blocks MB3e, third separation structures WLC3e, and third bit lines BL3e respectively corresponding to the second memory blocks MB2b, the second separation structures WLC2b, and the second bit lines BL2b of the second structure ST2b in FIG. 8A. The fourth structure ST4e may include fourth memory blocks MB4e, fourth separation structures WLC4b, and fourth bit lines BL4e respectively corresponding to the second memory blocks MB2b, the second separation structures WLC2b, and the second bit lines BL2b of the second structure ST2b in FIG. 8A.

Each of the first memory blocks MB1e may include first memory cell array regions MCA1e and a first extension region FA1e respectively corresponding to the first memory cell array regions MCA1b and the first extension region EA1b of the first memory block MB1b in FIG. 8A. Each of the second memory blocks MB2e may include second memory cell array regions MCA2e and a second extension region EA2e respectively corresponding to the first memory cell array regions MCA1b and the first extension region EA1b of the first memory block MB1b in FIG. 8A. Each of the third memory blocks MB3e may include third memory cell array regions MCA3e and a third extension region EA3e respectively corresponding to the second memory cell array regions MCA2b and the second extension region EA2b of the second memory block MB2b in FIG. 8A. Each of the fourth memory blocks MB4e may include fourth memory cell array regions MCA4e and a fourth extension region EA4e respectively corresponding to the second memory cell array regions MCA2b and the second extension region EA2b of the second memory block MB2b in FIG. 8A.

Each of the first and second structures ST1e and ST2e may have a shape in which the first memory cell array regions MC1b of the first structure ST1b in FIG. 8A are elongated in the first horizontal direction D1, and each of the third and fourth structures ST3e and ST4e may have a shape in which the second memory cell array regions MC2b of the second structure ST2b in FIG. 8A are elongated in the second horizontal direction D2. Accordingly, as compared to the first and second structures ST1b and ST2b in FIG. 8A, the first structure ST1e may include the first memory cell array regions MC1e having a shape elongated in the first horizontal direction D1, the second structure ST2e may include the second memory cell array regions MC2e having a shape elongated in the first horizontal direction D1, the third structure ST3e may include the third memory cell array regions MC3e having a shape elongated in the second horizontal direction D2, and the fourth structure ST4e may include the fourth memory cell array regions MC4e having a shape elongated in the second horizontal direction D2. Accordingly, the first and second structures ST1e and ST2e may include word lines extending in the first horizontal direction D1 and parallel to each other, and the third and fourth structures ST3e and ST4e may include word lines extending in the second horizontal direction D2 and parallel to each other.

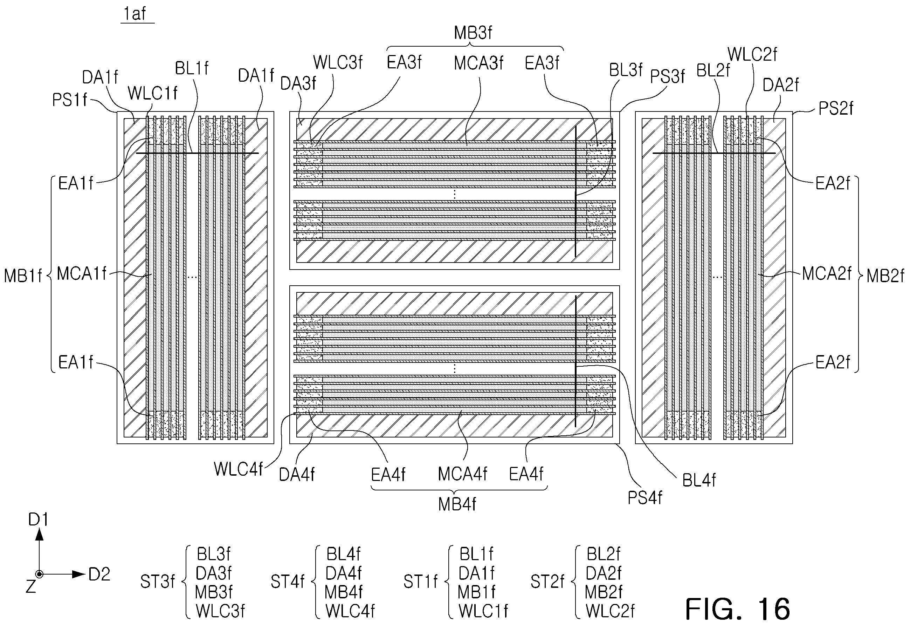

In a modification, referring to FIG. 16, a semiconductor device 1bf in the modification may include the first to fourth conductive plate structures PS1f, PS2f, PS3f, and PS4f spaced apart from each other, and the first to fourth structures ST1f, ST2f, ST3f, and ST4f spaced apart from each other.

The first and second conductive plate structures PS1f and PS2f may be spaced apart from each other in the second horizontal direction D2, and the third and fourth conductive plate structures PS3f and PS4f may be between the first and second conductive plate structures PS1f and PS2f, and may be spaced apart from each other in the first horizontal direction D1.

Each of the first and second conductive plate structures PS1f and PS2f may have a shape in which the first conductive plate structure PS1a in FIG. 1 is elongated in the first horizontal direction D1, and each of the third and fourth conductive plate structures PS3f and PS4f may have a shape in which the second conductive plate structure PS2a in FIG. 1 is elongated in the second horizontal direction D2.

The first structure ST1f may include first memory blocks MB1f, first separation structures WLC1f, first dummy regions DA1f, and first bit lines BL1f respectively corresponding to the first memory blocks MB1a, the first separation structures WLC1a, the first dummy regions DA1a, and the first bit lines BL1a in FIG. 1. The second structure ST2f may include second memory blocks MB2f, second separation structures WLC2f, second dummy regions DA2f, and second bit lines BL2f respectively corresponding to the first memory blocks MB1a, the first separation structures WLC1a, the first dummy regions DA1a, and the first bit lines BL1a of the first structure ST1a in FIG. 1. The third structure ST3f may include third memory blocks MB3f, third separation structures WLC3f, third dummy regions DA3f, and third bit lines BL3f respectively corresponding to the second memory blocks MB2a, the second separation structures WLC2a, the second dummy regions DA2a, and the second bit lines BL2a of the second structure ST2a in FIG. 1. The fourth structure ST4f may include fourth memory blocks MB4f, fourth separation structures WLC4f, fourth dummy regions DA4f, and fourth bit lines BL4f respectively corresponding to the second memory blocks MB2a, the second separation structures WLC2a, the second dummy regions DA2a and the second bit lines BL2a of the second structure ST2a in FIG. 1.

Each of the first memory blocks MB1f may include a first memory cell array region MCA1f and first extension regions EA1f respectively corresponding to the first memory cell array region MCA1a and the first extension regions EA1a of the first memory block MB1a in FIG. 1. Each of the second memory blocks MB2f may include a second memory cell array region MCA2f and second extension regions EA2f respectively corresponding to the first memory cell array region MCA1a and the first extension regions EA1a of the first memory block MB1a in FIG. 1. Each of the third memory blocks MB3f may include a third memory cell array region MCA3f and third extension regions EA3f respectively corresponding to the second memory cell array region MCA2a and the second extension regions EA2a of the second memory block MB2a in FIG. 1. Each of the fourth memory blocks MB4f may include a fourth memory cell array region MCA4f and fourth extension regions EA4f respectively corresponding to the second memory cell array region MCA2a and the second extension regions EA2a of the second memory block MB2a in FIG. 1.

Each of the first and second structures ST1f and ST2f may have a shape in which the first memory cell array region MC1a of the first structure ST1a in FIG. 1 is elongated in the first horizontal direction D1, and each of the third and fourth structures ST3f and ST4f may have a shape in which the second memory cell array region MC2a of the second structure ST2a in FIG. 1 is elongated in the second horizontal direction D2. Accordingly, as compared to the first and second structures ST1a and ST2a in FIG. 1, the first structure ST1f may include the first memory cell array region MC1f having a shape elongated in the first horizontal direction D1, the second structure ST2f may include the second memory cell array region MC2f having a shape elongated in the first horizontal direction D1, the third structure ST3f may include the third memory cell array region MC3f having a shape elongated in the second horizontal direction D2, and the fourth structure ST4f may include the fourth memory cell array region MC4f having a shape elongated in the second horizontal direction D2.

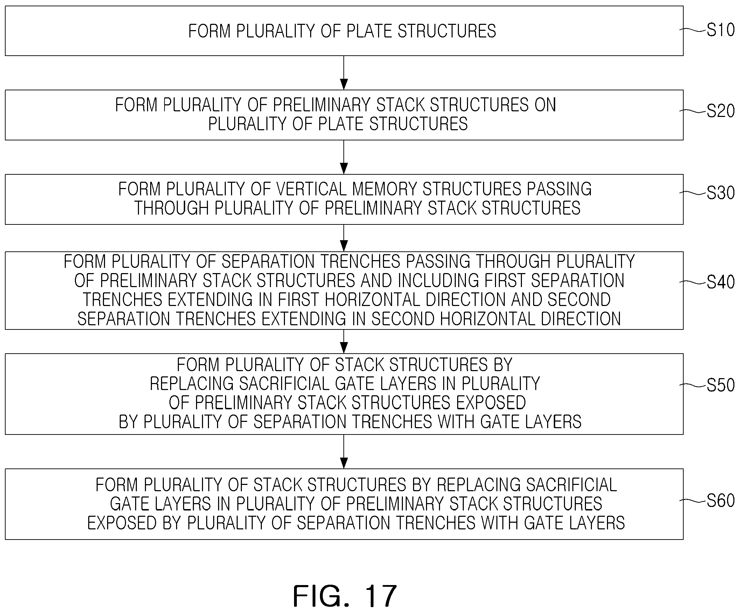

Subsequently, referring to FIG. 17, an example of a method of forming a semiconductor device according to an example embodiment will be described. FIG. 17 is a schematic process flowchart illustrating an example of a method of forming a semiconductor device according to some example embodiments.

Referring to FIG. 17, a plurality of plate structures may be formed (S10). The plate structures may be any of the conductive plate structures PS described above.

In some example embodiments, before the plurality of plate structures are formed, the lower structure 3 illustrated in FIGS. 2A and 2B may be formed.

A plurality of preliminary stack structures may be formed on the plurality of plate structures (S20). A plurality of vertical memory structures passing through the plurality of preliminary stack structures may be formed (S30).

A plurality of separation trenches, passing through the plurality of preliminary stack structures and including first separation trenches extending in a first horizontal direction and second separation trenches extending in a second horizontal direction, may be formed (S40).

A plurality of stack structures may be formed by replacing sacrificial gate layers in the preliminary stack structures exposed by the plurality of separation trenches with gate layers (S50). The gate layers may be the gate layers 35g and 59g described with reference to FIGS. 2A and 2B.

Separation structures filling the plurality of separation trenches may be formed. The separation structures may be the first and second separation structures WLC1a and WLC2a illustrated in FIG. 1.

A plurality of bit lines including first bit lines extending in the first horizontal direction and second bit lines extending in the second horizontal direction may be formed (S60). The first bit lines may be the first bit lines BL1a in FIG. 1, and the second bit lines may be the second bit lines BL2a in FIG. 1.

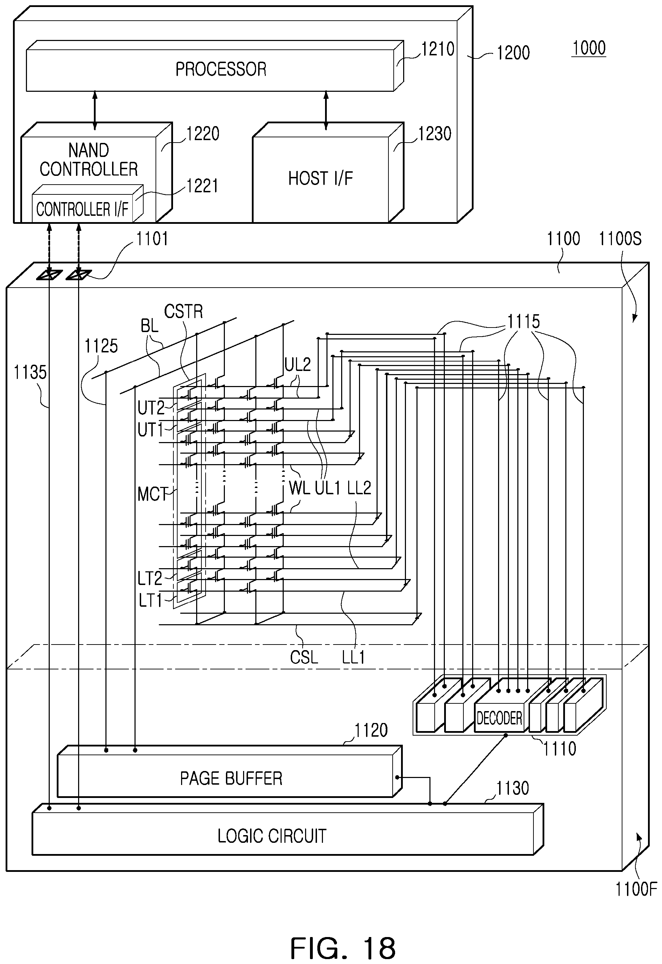

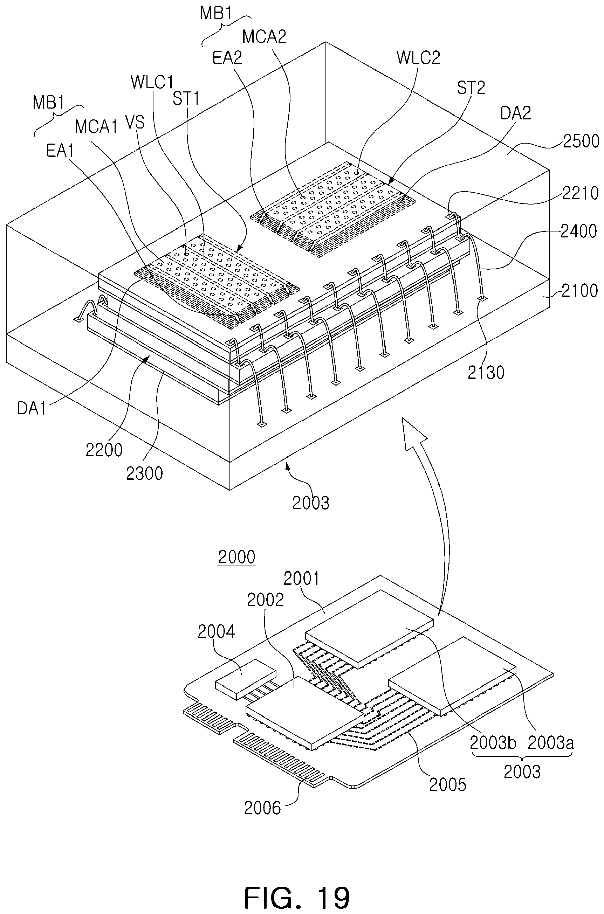

Subsequently, a data storage system including a semiconductor device according to some example embodiments will be described with reference to each of FIGS. 18 and 19.

FIG. 18 is a schematic view illustrating a data storage system including a semiconductor device according to some example embodiments.

Referring to FIG. 18, a data storage system 1000 according to some example embodiments may include a semiconductor device 1100 and a controller 1200 electrically connected to the semiconductor device 1100 to control the semiconductor device 1100. The data storage system 1000 may be a storage device including the semiconductor device 1100 or may be an electronic device that includes the storage device. For example, the data storage system 1000 may be a solid state drive device (SSD), a universal serial bus (USB), a computing system, a medical device, or a communication device including the semiconductor device 1100.

In some example embodiments, the data storage system 1000 may be an electronic system for storing data.

The semiconductor device 1100 may be a non-volatile memory device. For example, the semiconductor device 1100 may be a semiconductor device according to one of the example embodiments described above with reference to FIGS. 1 to 16. The semiconductor device 1100 may include a first structure 1100F and a second structure 11005 on the first structure 1100F.

The first structure 1100F may be a peripheral circuit structure including a decoder circuit 1110, a page buffer 1120, and a logic circuit 1130. For example, the first structure 1100F may include the peripheral circuit structure PERI described above. The peripheral circuit described above (e.g., peripheral circuit 10 in FIG. 2A) may be a transistor, which may be included in a decoder circuit 1110, a page buffer 1120, and a logic circuit 1130.

The decoder circuit 1110 may include the pass transistor circuit regions PC_C1a and PT_C2a described with reference to FIG. 6, and the page buffer 1120 may include the page buffer circuits PB_C1a and PB_C2a described with reference to FIG. 6.

The second structure 11005 may be a memory structure including bit lines BL, common sources CSL, word lines WL, first and second gate upper lines UL1 and UL2, first and second gate lower lines LL1 and LL2, and memory cell strings CSTR between the bit line BL and the common source CSL.

In the second structure 1 100S, each of the memory cell strings CSTR may include lower transistors LT1 and LT2 adjacent to the common source CSL, upper transistors UT1 and UT2 adjacent to the bit line BL, and a plurality of memory cell transistors MCT between the lower transistors LT1 and LT2 and the upper transistors UT1 and UT2. In some example embodiments, the number of lower transistors LT1 and LT2 and the number of upper transistors UT1 and UT2 may be modified in various manners.

The plurality of memory cell transistors MCTs may include gate layers, which may be word lines among the gate layers (e.g., gate layers 35g and 59g in FIGS. 2A and 2B) described above, the channel layer (e.g., channel layer 77 in FIG. 2C), and the data storage structure (e.g., data storage structure 75 in FIG. 2C).

In some example embodiments, the upper transistors UT1 and UT2 may include string selection transistors, and the lower transistors LT1 and LT2 may include ground selection transistors. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

The gate layers (e.g., gate layers 35g and 59g in FIGS. 2A and 2B) described above may be included in the gate lower lines LL1 and LL2, the word lines WL, and the gate upper lines UL1 and UL2.

The common source CSL, the first and second gate lower lines LL1 and LL2, the word lines WL, and the first and second gate upper lines UL1 and UL2 may be electrically connected to the decoder circuit 1110 through first connection wirings 1115 extending to the second structure 11005 within the first structure 1100F.

The bit lines BL may be electrically connected to the page buffer 1120 through second connection wirings 1125 extending to the second structure 11005 within the first structure 1100F.

As an example, the second structure 1 1005 may be one of a structure including the first conductive plate structure PS1a and the first structure ST1a, and a structure including the second conductive plate structure PS2a and the second structure ST2a. It may be described that the first conductive plate structure PS1a and the first structure ST1a in FIG. 1 include the common source CSL, the first and second gate lower lines LL1 and LL2, word lines WL, the first and second gate upper lines UL1 and UL2, and the bit lines BL, and the second conductive plate structure PS2a and the second structure ST2a in FIG. 1 include the common source CSL, the first and second gate lower lines LL1 and LL2, word lines WL, the first and second gate upper lines UL1 and UL2, and the bit lines BL.

In the first structure 1100F, the decoder circuit 1110 and the page buffer 1120 may perform a control operation on at least one selected memory cell transistor MCT among the plurality of memory cell transistors MCT. The decoder circuit 1110 and the page buffer 1120 may be controlled by a logic circuit 1130.

The semiconductor device 1000 may further include an input/output pad 1101. The semiconductor device 1000 may communicate with the controller 1200 through the input/output pad 1101 electrically connected to the logic circuit 1130. The input/output pad 1101 may be electrically connected to the logic circuit 1130 through an input/output connection wiring 1135 extending to the second structure 1100S within the first structure 1100F. Accordingly, the controller 1200 may be electrically connected to the semiconductor device 1000 through the input/output pad 1101, and may control the semiconductor device 1000.

The controller 1200 may include a processor 1210, a NAND controller 1220, and a host interface (I/F) 1230. In some example embodiments, the data storage system 1000 may include a plurality of semiconductor devices 1100. In this case, the controller 1200 may control the plurality of semiconductor devices 1000.

The processor 1210 may control overall operations of the data storage system 1000 including the controller 1200. The processor 1210 may operate depending on predetermined firmware, and may access the semiconductor device 1100 by controlling the NAND controller 1220. The NAND controller 1220 may include a NAND interface 1221 processing communication with the semiconductor device 1100. A control instruction for controlling the semiconductor device 1100, data to be written to the memory cell transistors MCT of the semiconductor device 1100, and data to be read from the memory cell transistors MCT of the semiconductor device 1100 may be transmitted through the NAND interface 1221. The host interface 1230 may provide a communication function between the data storage system 1000 and an external host. When a control instruction is received from the external host through the host interface 1230, the processor 1210 may control the semiconductor device 1100 in response to the control instruction.

FIG. 19 is a schematic perspective view illustrating a data storage system including a semiconductor device according to some example embodiments.

Referring to FIG. 19, a data storage system 2000 according to some example embodiments may include a main substrate 2001, a controller 2002 mounted on the main substrate 2001, one or more semiconductor packages 2003, and a DRAM 2004. The semiconductor packages 2003 and the DRAM 2004 may be connected to the controller 2002 through wiring patterns 2005 formed on the main substrate 2001.

The main substrate 2001 may include a connector 2006 including a plurality of pins that couple to an external host. The number and arrangement of the plurality of pins in the connector 2006 may vary depending on a communication interface between the data storage system 2000 and the external host. In some example embodiments, the data storage system 2000 may communicate with the external host according to one of interfaces such as universal flash storage (UFS), peripheral component interconnect express (PCI-Express), serial advanced technology attachment (SATA), M-Phy for universal serial bus (USB), and/or the like. In example embodiments, the data storage system 2000 may be operated by power supplied from the external host through the connector 2006. The data storage system 2000 may further include a power management integrated circuit (PMIC) configured to distribute, to the controller 2002 and to the semiconductor package 2003, power supplied from the external host.

The controller 2002 may write data to the semiconductor package 2003 or read data from the semiconductor package 2003, and may improve operating speed of the data storage system 2000.

The DRAM 2004 may be a buffer memory that may alleviate a speed difference between the semiconductor package 2003, a data storage space, and the external host. The DRAM 2004, included in the data storage system 2000, may also operate as a type of cache memory, and may provide a space for temporarily storing data in a control operation on the semiconductor package 2003. When the DRAM 2004 is included in the data storage system 2000, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the semiconductor chips 2200 may include a semiconductor device according to one of the example embodiments described above with reference to FIGS. 1 to 16.

Each of the first and second semiconductor packages 2003a and 2003b may include a package substrate 2100, semiconductor chips 2200 on the package substrate 2100, adhesive layers 2300 on a lower surface of each of the semiconductor chips 2200, a connection structure 2400 electrically connecting the semiconductor chips 2200 and the package substrate 2100 to each other, and a molding layer 2500 covering the semiconductor chips 2200 and the connection structure 2400 on the package substrate 2100.

The package substrate 2100 may be a printed circuit board including package upper pads 2130. Each of the semiconductor chips 2200 may include an input/output pad 2210.

In some example embodiments, the connection structure 2400 may be a bonding wire electrically connecting the input/output pad 2210 and the package upper pads 2130 to each other. Accordingly, in each of the first and second semiconductor packages 2003a and 2003b, the semiconductor chips 2200 may be electrically connected to each other using a bonding wire method, and may be electrically connected to the package upper pads 2130 of the package substrate 2100. In some example embodiments, in each of the first and second semiconductor packages 2003a and 2003b, the semiconductor chips 2200 may be electrically connected to each other by a connection structure including a through-silicon via (TSV) instead of the connection structure 2400 using the bonding wire method.

In some example embodiments, the controller 2002 and the semiconductor chips 2200 may be included in one package. For example, the controller 2002 and the semiconductor chips 2200 may be mounted on an interposer substrate, different from the main substrate 2001, and the controller 2002 and the semiconductor chips 2200 may be connected to each other by a wiring formed on the interposer substrate.

In the semiconductor package 2003, the package substrate 2100 may be a printed circuit board.

Each of the semiconductor chips 2200 may include a semiconductor device according to one of the example embodiments described above with reference to FIGS. 1 to 16. For example, each of the semiconductor chips 2200 may include a first structure ST1 and a second structure ST2 spaced apart from each other.

The first structure ST1 may include first separation structures WLC1 and first memory blocks MB1 spaced apart from each other by the first separation structures WLC1, and the second structure ST2 may include second separation structures WLC2 and second memory blocks MB2 spaced apart from each other by the second separation structures WLC2. The first structure ST1 may further include first dummy regions DA1, as illustrated in FIG. 1, and the second structure ST2 may further include second dummy regions DA2, as illustrated in FIG. 1.

Each of the first memory blocks MB1 may include a first memory cell array region MCA1 and a first extension region EA1. Each of the second memory blocks MB2 may include a second memory cell array region MCA2 and a second extension region EA2. Each of the first and second structures ST1 and ST2 may further include vertical memory structures VS in the first and second memory cell array regions MCA1 and MCA2.

As described above, each of the first memory blocks MB1 may extend in a first horizontal direction, and each of the second memory blocks MB2 may extend in a second horizontal direction. The first and second horizontal directions may cross each other and may be perpendicular to each other.

According to some example embodiments, a semiconductor device including first and second memory blocks, extending in different directions, at the same height level may be provided. As described above, the first memory blocks and the second memory blocks may be provided to extend in different directions that are perpendicular to each other, which may thereby minimize warpage of the semiconductor device. Accordingly, defects of the semiconductor device caused by warpage may be prevented, and the semiconductor device may have improved reliability due to the minimized warpage.

In addition, since warpage is minimized, the number of word lines stacked in the first and second memory blocks may be increased. Accordingly, a degree of integration of the semiconductor device may be increased.

The various and beneficial advantages and effects of the present disclosure are not limited to those explicitly provided above, and will be more easily understood in the course of describing specific example embodiments of the present disclosure.

While some example embodiments have been shown and described above, it will be apparent to those skilled in the art that modifications and variations could be made without departing from the scope of the present disclosure as defined by the appended claims.

## Claims

1. A semiconductor device comprising:
a first conductive plate structure and a second conductive plate structure, arranged at a same vertical level on a semiconductor chip and spaced apart horizontally from each other on the semiconductor chip;
a first structure on the first conductive plate structure and including first separation structures and first memory blocks; and
a second structure on the second conductive plate structure and including second separation structures and second memory blocks,
wherein the first memory blocks are spaced apart from each other by the first separation structures, and extend in parallel to each other in a first horizontal direction,
wherein the second memory blocks are spaced apart from each other by the second separation structures, and extend in parallel to each other in a second horizontal direction, and
wherein the first and second horizontal directions are parallel to an upper surface of the first conductive plate structure, and are perpendicular to each other.

2. The semiconductor device of claim 1,
wherein the first conductive plate structure includes a first common source,
wherein the second conductive plate structure includes a second common source,
wherein each of the first memory blocks includes:
first word lines spaced apart from each other in a vertical direction; and
first vertical memory structures that extend through the first word lines and electrically connected to the first common source, and
wherein each of the second memory blocks includes:
second word lines spaced apart from each other in the vertical direction; and
second vertical memory structures that extend through the second word lines and electrically connected to the second common source.

3. The semiconductor device of claim 2, further comprising a peripheral circuit structure that vertically overlaps the first and second structures, wherein the peripheral circuit structure includes:
a first pass transistor circuit region including first pass transistors electrically connected to the first word lines; and
a second pass transistor circuit region including second pass transistors electrically connected to the second word lines.

4. The semiconductor device of claim 3,
wherein the first pass transistor circuit region has a shape that is elongated in the second horizontal direction, and
wherein the second pass transistor circuit region has a shape that is elongated in the first horizontal direction.

5. The semiconductor device of claim 3 or claim 4,
wherein the first conductive plate structure is between the peripheral circuit structure and the first structure, and
wherein the second conductive plate structure is between the peripheral circuit structure and the second structure.

6. The semiconductor device of claim 3 or claim 4,
wherein the first structure is between the first conductive plate structure and the peripheral circuit structure, and
wherein the second structure is between the second conductive plate structure and the peripheral circuit structure.

7. The semiconductor device of any one of claims 2-6,
wherein each of the first memory blocks has a first memory cell array region and a first extension region that are adjacent to each other in the first horizontal direction,
wherein each of the second memory blocks has a second memory cell array region and a second extension region that are adjacent to each other in the second horizontal direction,
wherein the first vertical memory structures extend through the first word lines in the first memory cell array region,
wherein the second vertical memory structures extend through the second word lines in the second memory cell array region,
wherein the first word lines include first word line pads arranged to have a stair shape in the first extension region, and
wherein the second word lines include second word line pads arranged to have a stair shape in the second extension region.

8. The semiconductor device of any one of claims 2-6,
wherein each of the first memory blocks has first memory cell array regions that are spaced apart from each other in the first horizontal direction, and a first extension region between the first memory cell array regions,
wherein each of the second memory blocks has second memory cell array regions that are spaced apart from each other in the second horizontal direction, and a second extension region between the second memory cell array regions,
wherein the first extension region includes a first connection region and a first stair region,
wherein the second extension region includes a second connection region and a second stair region,
wherein the first vertical memory structures extend through the first word lines in the first memory cell array regions,
wherein the second vertical memory structures extend through the second word lines in the second memory cell array regions,
wherein the first word lines continuously extend in the first memory cell array regions and the first connection region,
wherein the first word lines include first word line pads arranged to have a stair shape in the first stair region,
wherein the second word lines continuously extend in the second memory cell array regions and the second connection region, and
wherein the second word lines include second word line pads arranged to have a stair shape in the second stair region.

9. The semiconductor device of any preceding claim, further comprising:
a third conductive plate structure on the semiconductor chip; and
a third structure on the third conductive plate structure and including third separation structures and third memory blocks,
wherein the third memory blocks are spaced apart from each other by the third separation structures, and extend in parallel to each other in the first horizontal direction, and
wherein the second conductive plate structure is between the first and third conductive plate structures.

10. The semiconductor device of claim 9, further comprising:
a fourth conductive plate structure on the semiconductor chip; and
a fourth structure on the fourth conductive plate structure and including fourth separation structures and fourth memory blocks,
wherein the fourth memory blocks are spaced apart from each other by the fourth separation structures, and extend in parallel to each other in the second horizontal direction, and
wherein the third and fourth conductive plate structures are spaced apart from each other,.

11. The semiconductor device of any one of claims 1-8, further comprising:
a third conductive plate structure on the semiconductor chip;
a fourth conductive plate structure on the semiconductor chip;
a third structure on the third conductive plate structure and including third separation structures and third memory blocks; and
a fourth structure on the fourth conductive plate structure and including fourth separation structures and fourth memory blocks,
wherein the third memory blocks are spaced apart from each other by the third separation structures, and extend in parallel to each other,
wherein the fourth memory blocks are spaced apart from each other by the fourth separation structures, and extend in parallel to each other,
wherein the first to fourth conductive plate structures are spaced apart from each other,
and
wherein the first to fourth structures are spaced apart from each other.

12. The semiconductor device of claim 11,
wherein the first and second conductive plate structures are adjacent to each other in the second horizontal direction,
wherein the third and fourth conductive plate structures are adjacent to each other in the second horizontal direction,
wherein the first and third conductive plate structures are adjacent to each other in the first horizontal direction,
wherein the second and fourth conductive plate structures are adjacent to each other in the first horizontal direction,
wherein each of the third memory blocks extends in the second horizontal direction, and
wherein each of the fourth memory blocks extends in the first horizontal direction.

13. The semiconductor device of any preceding claim,
wherein the first structure further includes first bit lines that cross the first memory blocks, on the first memory blocks,
wherein the second structure further includes second bit lines that cross the second memory blocks, on the second memory blocks,
wherein each of the first bit lines extends in the second horizontal direction, and
wherein each of the second bit lines extends in the first horizontal direction.

14. A data storage system comprising:
a semiconductor device according to any preceding claim, wherein the semiconductor device further includes an input/output pad; and
a controller electrically connected to the semiconductor device through the input/output pad, the controller configured to control the semiconductor device.
